# EUROPEAN PATENT APPLICATION

(11) **EP 4 376 047 A2**
(43) Date of publication of application: **29.05.2024**
(21) Application number: 23020512.2
(22) Date of filing: 20.11.2023
(51) Int. Cl.: H01J 37/04, H01J 37/147, H01J 37/15

(54) **PARTICLE BEAM SYSTEM**

(30) Priority: 22.11.2022 US 202217992007
(71) Applicant: Podhola, Kamil, 46311 Liberec 30 (CZ)
(72) Inventor: Podhola, Kamil, 46311 Liberec 30 (CZ)

(57) **Abstract**

The invention relates to a particle beam system (PBS) comprising a particle guiding tube 101, one or more transversely movable electrodes 102a,b (of a defined type) providing a transverse electric and/or magnetic field (pulse or linear) wherein a particle flow can be influenced by the electrodes which can further have a defined shape. The PBS can be provided with a protective film and/or an insulation, it can form a mono and/or stereo particle path. The PBC can provide a cross-sectionally shaped beam, an adjustable optical axis, a rotating electric and/or magnetic field, a circularly polarized beam. The PBS can form an array, it can comprise one or more connections, one or more modules. The PBC can be coupled with electro- and/or mechanocomponents. The PBC can form lenses configured in a separate eye ray configuration. A method for providing a particle beam and a digitizer of photographic or X-ray images are proposed.

## Description

### Technical Field

The invention relates to a controllable particle beam system.

### Background Art

An electrostatic lens is a device that assists in the transport of charged particles like electrons emitted from a sample to an analyzer. An electrostatic lens can magnify and/or converge the electron trajectories, can focus an ion (micro-) beam.

US8466430B2 (Kazuhiro Sando [JP]) 5 October 2010 (2010-10-05) discloses an electrostatic lens including multiple electrodes each having a through hole, and an insulating spacer provided between the electrodes and fixing an interval between the electrodes having a protective insulating film disposed on the surfaces, the film is further disposed on the interior wall of the through hole and in an around region and extending to an electrode end portion. The protective film is not provided between the electrode and the spacer. Electrodes can be Si electrodes.

US2986669A (Nobuo J Koda [US]) 6 January 1959 (1959-01-06) discloses a cathode ray tube having a matrix through apertures of which passes an electron beam to produce a particular crosssectional beam configuration, an electrostatic lens system is provided comprising first and second symmetrical lenses about the aperture matrix and a third lens on the side of the second lens farthest from the matrix to focus the latter on the plane of a storage target. The beam is directed to a predetermined aperture by a deflecting system.

The above cited documents fails to disclose mutually movably arranged electrodes providing a pulse electric and/or magnetic field.

The above information disclosed in this background section is only for enhancement of understanding of the background of the invention and, therefore, it may contain information that does not form any part of the prior art nor what the prior art may suggest to a person of ordinary skill in the art.

### Disclosure of Invention

The object of the present invention is to propose a particle beam system comprising a particle guiding tube, one or more transversely movable electrodes providing a transverse electric and/or magnetic field wherein a particle flow can be influenced by the electrodes.

A further object is to propose the system with the one or more electrodes having a defined shape.

A further object is to propose the system providing a pulse or linear electric, magnetic or electromagnetic field.

A further object is to propose the system with a component provided with a protective film.

A further object is to propose the system with the particle guiding tube insulated with a defined insulation layer.

A further object is to propose the system forming mono and/or stereo particle paths.

A further object is to propose the system producing a cross-sectionally shaped beam wherein the cross-sectional shape can be further defined.

A further object is to propose the system providing an adjustable optical axis.

A further object is to propose the system producing a rotating electric or magnetic or electromagnetic field.

A further object is to propose the system providing a circularly polarised particle beam.

A further object is to propose the system forming an array.

A further object is to propose the system comprising one or more connections.

A further object is to propose the system with the electrodes being further defined.

A further object is to propose the system coupled with a defined electrocomponent and/or mechanocomponent.

A further object is to propose the system comprising one or more modules.

A further object is to propose the system forming lenses in a separated eye ray configuration.

Another object is to propose a method for providing a particle beam comprising the steps of providing the above defined particle beam system, transversely relatively moving the electrodes and influencing the particle flow.

Still another object is to propose a digitizer of photographic or X-ray images, the system comprising a first portion including a source of charged particles, a particle guiding tube, a particle lens system having transversely movable electrodes and a second portion including a scanning screen coupled with an image processor.

In a first aspect, the invention discloses the particle beam system.

In a second aspect, the invention discloses the method for providing a particle beam.

In a third aspect, the invention discloses the digitizer of photographic or X-ray images.

### Brief Description of Drawings

The invention will now be described by way of example. Only essential elements of the invention are schematically shown and not to scale to facilitate immediate understanding, emphasis being placed upon illustrating the principles of the invention.
FIG. 1 is a schematic longitudinal cross sectional view of a particle beam system (PBS) with particles guiding tube and transversely mutually movable electrodes providing a transverse electric and/or magnetic field.
FIG. 2 is a schematic cross sectional view of a PBS.
FIG. 3 is a schematic longitudinal cross sectional side view of a PBS providing particles acceleration.
FIG. 4 is a schematic oblique view of a PBS comprising a connection.
FIG. 5 is a schematic longitudinal cross sectional side view of a PBS array.
FIG. 6 is a schematic oblique view of a focusing PBS array.
FIG. 7 is a schematic longitudinal cross sectional side view of a focusing PBS.
FIG. 8 is a schematic perspective illustration of a PBS forming a deflecting path.
FIG. 9 is a schematic cross sectional illustration of a PBS for producing a cross sectional V shaped electron beam.
FIG. 10 is a schematic side view of shaped electrodes provided for a PBS.
FIG. 11 is a schematic side view of pairs of electrodes provided for a PBS producing a rotating electric and/or magnetic field.
FIG. 12 is a schematic oblique view of a PBS forming a matrix.
FIG. 13 is a schematic oblique view of a PBS comprising an insulation.
FIG. 14 is a schematic oblique view of a PBS providing a rotating electric and/or magnetic field.
FIG. 15 is a schematic oblique view of a PBS providing electrostatic diverging lenses.
FIG. 16 is a schematic oblique view of a PBS providing various diameters guide tubes.
FIG. 17 is a schematic oblique view of a PBS providing an electrostatic diverging lenses array.
FIG. 18 is a schematic oblique view of a PBS comprising beam image controllers.
FIG. 19 is a schematic oblique view of a PBS comprising a source vacuum enclosure, a system vacuum enclosure and an enlarged portion.
FIG. 20 is a schematic perspective view of a PBS provided in a probe sampler.
FIG. 21 is a schematic perspective view of a PBS providing electrostatic flat convex lenses.
FIG. 22 is a schematic perspective view of a PBS providing an image controller.
FIG. 23 is a schematic front view of a PBS comprising a variable controllable electromagnetic or electrostatic lens.
FIG. 24 is a schematic front view of a PBS comprising a variable controllable electromagnetic or electrostatic lens.
FIG. 25 is a schematic perspective illustration of an actuator usable in a PBS comprising a variable controllable electromagnetic or electrostatic lens.
FIG. 26 is a schematic perspective illustration of a PBS provided as an apparatus for digitalization of photographic negatives or X-ray photos.
FIG. 27 is a schematic oblique view of pairs of transversely movable electrodes provided in windings.
FIG. 28 is a schematic front view of a PBS provided in a particle beam stereovision system.
FIG. 29 is a schematic perspective illustration of a PBS provided in pairs forming lenses.
FIG. 30 is a schematic perspective illustration of a PBS providing transversely movable electrode pairs.
FIG. 31 is a schematic partial detailed cross sectional view of a transversely movable electrode provided in a partial vacuum/atmosphere mode.
FIG. 32 is a schematic partial detailed cross sectional view of transversely movable electrodes having a defined shape and coupled with actuators.
FIG. 33 is a schematic perspective illustration of an apparatus with an adjustable optical axis.
FIG. 34 is a schematic side view of another apparatus with an adjustable optical axis.
FIG. 35 is a schematic oblique view of a shaped charged particle beam utilizable by various types of machines.
FIG. 36 is a schematic oblique view of an apparatus provided in a gas cluster ion beam.
FIG. 37 is a schematic side view of a multi-beam apparatus.
FIG. 38 is a schematic side view of an apparatus providing a charged particle cluster beam.
FIG. 39 is a schematic side view of an apparatus according to the present invention which can comprise transversely movable electrodes and fixed electrodes.
FIG. 40 is a schematic oblique view of a multi-beamlet apparatus according to the present invention which can comprise a transversely movable split electrode and a fixed electrode.
FIGs. 41a and 41b are schematic oblique views of an apparatus providing a circularly non-polarized and a circularly polarized beam.
FIG. 42 is a schematic cross sectional view of an apparatus with a non-circular beam guiding tube.
FIG. 43 is a schematic side view of an apparatus with a plurality of pairs of transversely movable electrodes.
FIG. 44 is a schematic oblique view of an apparatus with a beam guiding tube havig portions with different diameters.
FIG. 45 is a schematic perspective illustration of an apparatus with perpendicularly oriented pairs of transversely movable electrodes.
FIG. 46 is a schematic cross sectional view of an apparatus according to the present invention providing a cross-shaped particle flow.

### Best Mode for Carrying Out the Invention

The following detailed description shows the best contemplated modes of exemplary embodiments. The description is made for the purpose of illustrating the general principles of the invention, and in such a detail that a skilled person in the art can recognise the advantages of the invention, and can be able to make and use the invention. Additional advantages may be learned by practice of the invention. The detailed description is not intended to limit the principle of the presented invention, but only to show the possibilities of it. The description and the detailed description are exemplary and explanatory only.

In the following description, for the purposes of explanation, numerous specific details are set forth in order to provide a thorough understanding of various exemplary embodiments. It is apparent, however, that various exemplary embodiments may be practiced without these specific details or with one or more equivalent arrangements. In other instances, well-known structures and devices are shown in a diagram form in order to avoid unnecessarily obscuring various exemplary embodiments.

In the accompanying figures, the size and relative sizes of layers and/or regions may be exaggerated for clarity and descriptive purposes. Also, like reference numerals denote like elements.

Since there are more embodiments of the invention shown in the drawings, no reference numerals has been introduced into the claims for clarity purposes.

The terms used in the claims and the specifications shall refer to their synonyms as well.

As used in the claims and the specification, the term "particles guiding tube" shall refer to electron-beam or ion-beam tubes, discharge tubes for evacuatin by diffusion of ions, apparatuses using ion pumps, cathode ray tubes, flying-spot tubes, etc.; the term shall refer to tubes forming electron beams, narrow electron beams by an electron lens; the term shall refer to electron optical systems, electron or ion columns; acceleration, focussing, etc., columns; mirror electron columns, reflection electron columns, columns with electromagnetic lenses, small-sized electron microscope columns, microscopes with dimension measurement systems, scanning electron microscopes, transmission electron microscopes, stereoscopes, etc.

As used in the claims and the specification, the term "particles" shall refer to ions, atoms, clusters, gas cluster ions (with a single or small multiple charge), monomers (single atoms or molecules), dimers, trimers, ligands, electrons, charged particles, negatons, positrons, combinations; the term shall refer to forward-scattered beams of atoms and conventional ions, to neutral atom beams, micro-ion-beams, energetic atom beams, charged particle pulses, multiple charged particle beams, etc.

As used in the claims and the specification the term "influenced" shall refer to extracted, accelerated, decelerated, focused, defocused, filtered, clustered, etc.

As used in the claims and the specification the term "processor" shall refer to microprocessors, field-programmable arrays, controllers, application-specific intergrated circuits, computing devices, etc. The computing devices can be further coupled with a local area network (LAN), a wide area network (WAN) such as the Internet, cloud/fog/edge computing systems, etc.

As used in the claims and the specification the term "memory" shall refer to volatile and non-volatile media, removable and non-removable media, optical media, random access memory, dynamic random access memory (DRAM), read-only memory, etc. The term shall refer to a hard disk, a CD-R, digital versatile disc (DVD), a memory card, an USB memory, a flash memory, etc. The memory may store instructions for programs, algorithms, etc., executable by the processor to perform a desired function.

As used in the claims and the specification, the term semiconductor shall refer to semiconductor materials including a wide range of materials that may have their electrical properties manipulated by the introduction of dopant materials, and can include for example silicon, germanium, diamond, silicon carbide, compound materials comprising group III-IV elements, group II-VI elements, etc.

As used in the claims and the specification, "A/B" shall refer to A and/or B.

As used in the claims and the specification, the singular forms are intended to include the plural forms as well and vice versa.

The terms "to comprise", "to include", "to contain", "to provide" and derivatives specify the presence of an element, but do not preclude the presence or addition of one or more other elements or groups and combinations thereof.

The term "consisting of" characterises a Markush group which is by nature closed. Single members of the group are alternatively useable for the purpose of the invention. Therefore, a singular if used in the Markush group would indicate only one member of the group to be used. For that reason are the countable members listed in the plural. That means together with qualifying language after the group "or combinations thereof that only one member of the Markush group can be chosen or any combination of the listed members in any numbers. In other words, although elements in the Markush groups may be described in the plural, the singular is contemplated as well. Furthermore, the phrase "at least one" preceding the Markush groups is to be interpreted that the group does not exclude one or more additional elements preceded by the phrase.

The invention will be described in reference to the accompanying drawings.

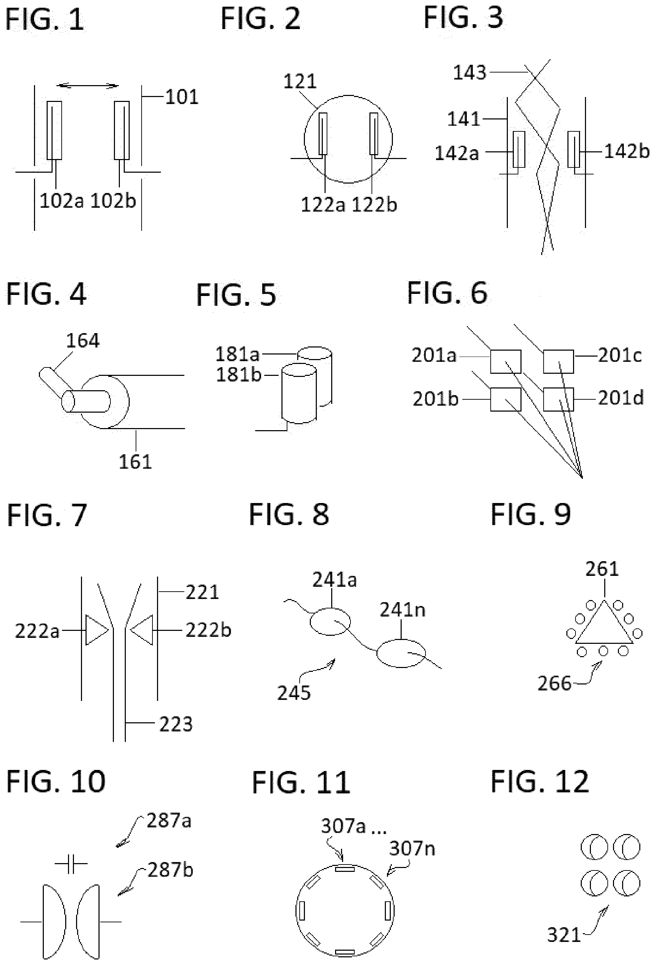

FIG. 1 is a schematic longitudinal cross sectional view of a particle beam system (PBS) comprising a particles guiding tube (101) [which can be provided e.g. as a short metallic cylinder or any electron permeable conductive element which can be coupled with an electron beam source /which can be of tungsten, zirconia, lanthanum hexaboride thermionic emitter, a field emission gun, such as a Schottky emitter or a cold cathode emitter, etc., which can be typically focused to a very small spot (because of electrons smaller than ions) and cause less damage to a sample; and which can be surrounded by high vacuum which can be pumped by sputter ion pumps, noble ion pumps, turbomolecular pumps, differential pumping systems, sublimation coils, cryogenic pumps, etc./, an electron gun for producing flood electrons /which can include a magnetic-field-superposed electron source, a carbon nanotube electron source, a field emitter source (a high brightness electron source), a thermal field emitter source, a filament source /or others point electron sources/, linear plasma or ion sources, inductively coupled plasma source, various types of plasma sources /e.g. plasma beam sources (PBS), unbalanced magnetron sources, hollow cathode plasma sources, hollow cathode sputter sources, gridded ion sources, end hall ion sources, closed drift type ion sources with an extended acceleration channel and anode layer types, impeded anode types, etc./, and which can include a heating element connected across a source of potential; and which can include an ion pump, a (sheet type) nonevaporative getter pump, a getter ion pump, pumps placed upstream and/or downstream, coils, (bar-shaped or other shapes) permanent magnets, magnetic materials, etc./, a cathode /coupled with a negative potential and a pulse generator which can allow an electron beam to flow through an aperture a desired period of time/, a valve assembly, accelerating electrodes /coupled with a positive potential/, a focusing electrode /e.g. electron beam columns typically use magnetic focusing lenses because of their lower aberration, whereas ion beam columns typically use electrostatic focusing lenses because an axcessively large current would be required to focus the heavy ions using a magnetic lens/, an intensity grid, a matrix /e.g. a thin conductive electrode plate/, imaging electrodes, cylinder electrodes forming a saddle lens, a compensating plates system /e.g. including perpendicularly oriented pairs of plates with positive potentials/, a deflection plates system /e.g. including perpendicularly oriented pairs of plates with positive potentials provided by voltage generators connected accross isolation resistors and capacitors; a deflection yoke can be used on the place of the plates, doughnut-shaped structures, etc./, a flood gun, collimating electrodes, a viewing screen /e.g. maintained at a high positive potential so as to accelerate electrons/, a storage screen, etc., and which can have various cross-sectional areas /e.g. circle, squared, V shaped, etc./], at least two transversely movably arranged electrodes (102a, 102b) [which can be energized by a voltage generator connected across isolation resistors and which can be directed through a selected aperture in the matrix] to provide a transverse electric field [which can be largely a symmetrical electrical converging field; the electric field can be provided in pulses which can minimize off-axis excursions and focus the particles' trajectories], wherein a charged particle flow can be accelerated and/or focused by the electrodes (102a, 102b) [which can be of various materials, sandwiched constructions /e.g. copper material sandwiched between electrically insulating material, etc./]. A convergence lens action can be provided by the invention by means of at least two electrodes (102a, 102b) providing two separate equal converging fields established on either side of the matrix so that no divergent action is exerced on an electron beam passing therethrough. The converged electron (or other particle) beam can have a trajectory at angle with respect to the axis of the tube (101). The system can act as extraction, preparation, acceleration or decelaration electrodes and as an electrostatic lens. The electrodes (102a, 102b) can draw electrons form the field emitter and can form a focus on an axis. The electrodes (102a, 102b) can be further aligned with other electrodes [e.g. intermediate, final electrodes, etc.] and can together form a field lens acting upon the beam produced by a charged particles generated from a source [e.g. a tip]. Extraction, accelerating and focusing potentials can be applied to the axially aligned field emission tip (gun), final electrode and intermediate electrodes. The electrode potentials can be selected to form positive or negative lens field and to produce a real focus of the charged particles outside the lens field and distal from of the field emission tip. The particles at the spot focus of the beam can be of a high or a low energy high intensity character. The final and the intermediate electrodes can act as a focusing lens on the beam as it passes through the electrode apertures [e.g. toward the target or specimen]. A main accelerating voltage can be e.g. applied to a final electrode, a lower potential voltage can be applied to the intermediate electrodes, thus a positive field between the final electrode and the intermediate electrode can be provided tending to converge the beam towards a focus at the specimen plate. A last (extraction) electrode can be placed closest to the field emission tip. The beam can be formed by the passes through the extraction, intermediate and electrodes respectively. The voltages provided to the extraction and the intermediate electrodes can be substantially equal thus providing the extraction field for the field emission tip. When used in the electron mode, these voltages can be positive and when used with a source of positive charged particles then the voltages should be reversed in potential causing an oppositely polarized field having the necessary intensity to form ions or other charged particles. The electrode apertures can be controllable by transveresly changing a distance between the electrodes (102a, 102b) according to the principle of the invention. A lens system can be further provided for control of the beam. The lens system can constitute deflection plates synchronised with a camera coupled to a computing device to obtain information about the specimen.

Detectors may be used to obtain information from the surface or through the specimen. The information may be obtained by detecting transmitted electons as in the case of a transmission electron microscope, secondary electrons, reflected electrons, absorbed electons, or other charged particle beam. The potential and electrodes distance control are intended to be provided in the programmed manner. In the scanning electron microscope the state of the sample may be observed by detecting the secondary electrrons generated from the sample surface.

A focused ion beam (FIB) device can detect the secondary electrons in the same manner as the scanning electron microscope and can also etch and deposit the sample by increasing the acceleration voltage. The FIB can have a following configuration - a first (plasma) [e.g. with a high aperture diameter to electrode thickness] and a second (extraction) electrode [other electrodes configured transversely movably according to the invention such as acceleration and focusing electrondes can be provided; a multibeamlet arrangement with a single ion source can be produced to increase throughput]. The FIB can be for example produced by an ion source or a plasma generator or a multicusp source [which can generate atomic or molecular ion barns of nearly any element and where a filament cathode can be replaced by a radio-frequency (RF) induction coil to produce a plasma by induction discharge], etc., can propagate through the FIB system composed of three stages [e.g. an ion extraciton section with an exit /which can have a tapered surface/ and an extractor electrode; an acceleration section with a plurality of accelerator electrodes /e.g. four/; a focusing section (Einzel lens) with three electrodes including a split electrode /which can be formed of four transversely movable isolated segments/; by applying voltages to the segments, a beam passing through a central aperture may be deflected or scanned and/or focused]; the electrodes can have various shapes /e.g. tapered (increasing the aspect ratio), knife-edge, constant diameter, etc.; /, radiuses of the apertures /which can be adjustable by movably arranged electrodes/, be provided with various voltages, etc.; other systems can be provided using movable electrodes], to produce a focused output beam [e.g. having a spot size down to 1 µm or less and a current greater than 1 µA]. Other components may be a coaxial magnetic filter, a workpiece hold, etc. The single-beam scanning FIB can be used in a mutliple beamlet system [a multi-beamlet can be generated by a single ion source together with a mulit-aperture acclerator column or multiple FIB units can be employed]. The (fast scanning) FIB system can be used for nanolithography and doping applications for semiconductor devices fabrications, e.g. using maskless and direct (photoresist-less) paterning and doping of films.

The scanning electron microscopes can detect electrons emitted from the sample as the beam scans the sample surface and can also alter a sample by inducing a chemical reaction on the surface or directly in the sample [e.g. to decompose the material /e.g. to mill copper/, to etch the material, to deposit a material on the sample surface, to blank a material, etc.]. TEM, FIB can also be provided to deposit a material, to etch a sample surface, etc. It is useful to prepare a sample using an FIB and then to use an SEM to image or to perform an energy dispersive spectroscopy (EDS) analysis. Two separate instruments or one combined dual-beam system with each optimized column for the type of particle beam that it produces can be used to perform the operation. A plasma chamber can be used as a source of electrons as well as ions [e.g. extracting ions from the plasma chamber can include extracting argon, xenon, or oxygen ions]. The configuration of the optical columns for focusing electrons and focusing ions, using the same column for both ions and electrons would result in less optimum resolution for ions, electrons, or both. So, the instrument can advantageously use the proposed preferably substantially transversely to the optical axis controllable electrodes provided in a single optical column according to the instrument's setting and the provided beam characteristic and type. The instrument can be for example set by an user to operate in ion-mode for FIB processing and electron-mode for SEM analysis, etc. X-ray detector [e.g. a silicon drift detector type], spectrometers or other spectrum analyzing systems may be attached to determine the physical properties of the sample.

Generally, the focused charged particle beam systems can be used to image, analyze, and modify samples on a microscopic or nanoscopic scale. Samples or substrates can include flexible webs, flat glass, three dimensional shapes, metals, silicon wafers, etc.

Transversely controllable electrodes according to the principle of the invention can be used e.g. as multiple electrostatic lenses in an FIB column [which can be constructed on a same platform as an SEM] on the place of a source biasing electrode, a beam acceptance aperture, a beam defining aperture, electrostatic (bipolar - accelerating or decelarating) einzel lenses, a pair of deflectors [e.g. parallel plate]. Other components can be provided such as an x-ray detector, respective actuators, a secondary electron detector collecting secondary electrons for forming an image scanning electron microscopy or scanning ion beam imaging, a gas injector for charged particle beam assisted etching and deposition, a contoller controlling the lateral position of the transversely movable electrodes, switching the respective electrode voltages [e.g. on the source biasing electrode, the extractor electrode, on other components]. Variable design parameters of the column according to the present invention such as position of the electrodes, provided voltages can be optimized for ion beams, electron beams, and various applications [e.g. in combination with different charged parcticle sources].

Voltages can be applied to the focusing lens according to the present invention for focusing the ion or the electrons according to the information obtained from an emitted field sensor, [e.g. x-rays can be collected at points on the sample, the collected spectrum may be analyzed to determine a map of the composition of different points on the sample in a vacuum chamber.]

The resolution of the scanning microscope depends in part upon the diameter of the beam. The smaller the electron beam diameter, the smaller the region from which secondary electrons will be emitted for imaging or that will be chemically altered. If the invention proposes the changing of the diameter of the beam, it also proposes the changing of the resolution. Primary electrons can cause the emission of other (secondary) electrons. The primary electrons also penetrate below a sample surface and are backscattered. The penetration depth and the quantity of backscattering depend upon the energy of the primary electrons and on the sample material. Returning backscattered electrons can cause emission of type II secondary electrons. Secondary electrons emitting area is larger than primary beam impact area. X-rays can escape from a much greater depth, so the interaction volume is much larger for x-rays than for secondary electrons and becomes a more critical factor for resolution than the beam spot size. The invention can thus indirectly influence the broadness of the secondary emitting area. The regulable aperture in according to the principle of the invention can further influence the chromatic aberration [which can be reduced using a smaller aperture] and the beam spread due to diffraction [which can be broadened using the smaller aperture]. The system can be tuned to a large enough convergence angle to reduce diffraction effects and a small convergence angle to reduce chromatic aberration which can be used to obtain high resolution images. Helium ions can be used instead of electrons in some applications, higher energies can be used in aberration correction. A lens (electrostatic or magnetic) can have a smaller focal lenght for low-energy particles than for higher energy particles. Low-energy particles are more deflected by an electric or magnetic deflection field than high-energy particles. Chromatic aberration is proportional to the energy spread in the beam. The proposed invention can change (electric or magnetic) deflection according to the spatial energy dispersion in the beam provided by a beam source. The transversely movable electrodes can be moved into a central position on a dispersion line or eccentrically. The result is that the lens does not image a point-like object as a round image as in case of the beam passing through the middle of the lens in a central position, but instead as a dispersion line, the passed beam will emerge from an apparently square image made outside the optical axis. Thus, beam properties can be selected [e.g. depending on an observation situation] by a combination of (electric or magnetic) lenses position on the optical axis of an apparatus [e.g. an electron microscope]. The particle source can be configured to be able to generate an energy beam type according to demand. Opening between the transversely movable electrodes according to the invention can be also regulated to achieve energy regulation, a beam-limiting function for both the central and the eccentric beam. Optical power of the lens can further be varied. A deflection unit can deflect the central and/or the eccentric beam and/or the right eye or left eye optical path toward an optical axis. Thus the shown principle can be advantageously used in stereoscopes.

Several movable electrodes units can be provided in a electron optical apparatus such as a monoscope or the stereoscope to converge electron (ion) beam paths into an optical axis by a stereo (electrostatic or magnetic) deflection unit. Non-selected beams can be blocked by diaphragms or the movable electrodes according to the invention placed behind the deflection unit. Ions can be easier focused and/or deflected by electrostatic electrodes causing at the same time greater chromatic aberration and energy dispersion. Additionally, the particle-emitting constituent surface can have the form of several, non-juxtaposed surfaces [e.g. provided for a central and eccentric position and/or for the left eye or right eye optical axis]; the surfaces can be provided each with assistive lenses. A voltage can be applied between the particle-emitting surface and the movable electrodes (or a diaphragm). The size of the provided opening by the movable electrodes determines the current in the beam (or right eye/left eye beams). The eccentricity (or left eye to right eye distance) determines the energy dispersion of the eccentric (or left eye and right eye) beam. The central and eccentric beams can be focused (similarly the left eye and the right eye beams) to form an image (the dispersion line). The transversely movable electrodes can be provided in opposite pairs thus forming a line-like image of the electron source which can cause artifacts. Another (e.g. perpendicular, in a radial direction, in a tangencial direction, etc.) dimension can thus be added by another pair of transveresly movable electrodes which can be provided in a same plane or juxtaposed. In that way, the electrons in the passed (focused, converged, etc.) beam will emerge from an approximately square portion of the image which will usually be sufficient approximation of the round form. The width of the image in the tangential direction is equal to the apparent size of the particle-emitting surface multiplied by the magnification of the (stereo-) lens. The by movable electrodes created aperture can be placed to the portion of different current density in the beam. Eccentric beams can afflict the image with astigmatism which can be cancelled with the aid of a stigmator unit which can be combined with a deflection unit.

The electron flux has a maximum at the electron beam axis, and decreases with increasing distance from the beam axis. The invention proposes a system which can regulate the electron flux by the transversely movable electrodes. The aspect ratio of a structure grown by beam chemistry can thus be changed. Fine structures can be produced using the regulated charged particle beam. The system of the invention can control adsorbate depletion, the electron beam energy and the diameter. A combination of low beam energy and adsorbate depletion control can yield superior resolution for beam-induced processing. In charged particle beam-induced growth, the proposed regulable system can affect the undesirable horizontal component of the growth driven by electrons emitted from deposit sidewalls. The horizontal component broadens the structures fabricated, limiting the resolution and aspect ratios. Thus, the proposed system can affect the overspray. Together with invention proposed regulation, the beam current can be modulated during etching or deposition. Apertures can also contribute in the same way as transveresely movable electrodes. The beam current can also be controlled by changing the excitation of a condenser lens controlling the beam diameter in the plane of the aperture. The change in the condenser lens alters the electron beam diameter at the sample surface which must be re-focused by adjusting an objective lens. Rapid blanking and unblanking of the beam can be used to modulate the fraction of electrons reaching the sample, thus the beam current can be additionally controlled. Conjugated blanking techniques can be used. Multiple (at least two) levels of beam current can be used [e.g. a high beam current for operations not demanding the high resolution]. The electron beam can be split into a beam travelling eccentrically through the regulable lens [and having lower chromatic aberration] and the other travelling through the center of the regulable lens [and having a greater current]. A (regulable) diaphragm can be used in the proposed system beyond the electron-emitting device to split the electron beam, to limit a portion of energy to pass, to select the portion of energy spectrum to be deflected towards an optical axis. The split beam can pass through a lens, through deflectors, and focused by an objective lens onto the sample wherein a voltage difference can be provided between the objective lens and the sample to reduce a landing energy. Similarly a focused ion beam and ion beam induced deposition can be used. Deposing times in the systems, duty cycles of the beam, etc., can be controlled by a controller.

A transmission electron microscope can sample preparation and photomask correction. A charged partical optical system for adjusting the caracteristic can be provided /e.g. in a focused ion beam apparatus an electrostatic lens can be an objective lens forming a focusing electric field focusing the ion beam [e.g. xenon ions] used as a charged particle optical system. A focal point can be provided on the sample. The electrostatic lens can be made rotationally symmetrically. An astigmatism correction [e.g. using two sets of quadrupoles] can be provided by the proposed system. Similarly a magnetic lens in a scanning electron microscope can be provided as an objective lens with an astigmatism correction mechanims provided by the proposed system. The system can be adjusted according to the direction of astigmatism. A control unit can adjust the input value of the optical system which can be composed of the applied voltage and the applied position [e.g. rotational] and distance between the electrodes (102a, 102b). A spot pattern forming unit can form a plurality of spot patterns on the surface of the sample. A plurality of spot patterns can be formed by irraidating the sample plurality of times by the charged particle beam and can be analyzed. A charged particle beam can be adjusted. A central control unit can control various subsystems [e.g. a five-axis stage, an ion or electron source power supply, a condenser lens control power supply, an objective lens control power supply, an aperture drive unit, a stigma control power supply, a scan electrode control power supply, a secondary electron detector, etc.]. The control unit can include an image processing means which can be monitored by a terminal, etc. Control can be manual, automated programmed, combinations.

The shown system of transversely movable electrodes can be applied in plasma accelerators, atomic motors, guns, etc. The transversely movable electrodes can be coupled with voltage sources of different potentials [e.g. (102a) with 10000V and (102b) 1V, etc.]. The particle guiding tube (101) can be coupled from one side with particle generators (not shown) and from other side with nozzles, turbines [e.g. with thick blades which can further operate alternators], etc. The transversely movable electrodes can have various angles with regard to an axis of the guiding tube (101) [e.g. the electrodes can diverge, converge, be parallel, etc.; the angles can be gradually changed]. The capacitive or electromagnetic transversely movable electrodes can accelerate particles in vacuum to very high speeds due to the intense Coulomb force.

FIG. 2 is a schematic cross sectional view of a PBS comprising a particles guiding tube (121), at least two transversely movably arranged electrodes (122a, 122b) to provide a transverse electric field, wherein a charged particle flow can be accelerated and/or focused by the electrodes (122a, 122b).

FIG. 3 is a schematic longitudinal cross sectional view of a PBS comprising a particles guiding tube (141), at least two transversely movably arranged electrodes (142a, 142b) to provide a transverse electric field, wherein a charged particle flow (143) can be accelerated by the electrodes (142a, 142b).

FIG. 4 is a schematic oblique view of a PBS comprising an insulated particles guiding tube (161) and a connection (164) [which can be a tap on a resistor, etc.].

FIG. 5 is a schematic oblique view of a PBS array comprising particles guiding tubes (181a, 181b).

FIG. 6 is a schematic oblique view of a PBS array comprising particles guiding tubes (201a, 201b, 201c, 201d).

FIG. 7 is a schematic longitudinal cross sectional view of a PBS comprising a particles guiding tube (221), at least two transversely movably arranged electrodes (222a, 222b) to provide a transverse electric field, wherein a charged particle flow (223) can be focused by electrodes (222a, 222b). [The PBS can provide an electrostatic convergence action on the beam prior to passage thereof through a matrix.]

FIG. 8 is a schematic perspective illustration of a PBS comprising a particles guiding tube (241a to 241n) forming a deflecting path (245) [off-axis excursions or deflections of the beam may be necessary to achieve a particular aperture in a matrix, limiting off-axis excursions can reduce pin cushion distortion in an array; reduction of the electrostatic lens diameter /i.e. the guiding tube diameter/ can make possible the utilization of a magnetic deflection system directing a shaped beam].

FIG. 9 is a schematic cross sectional illustration of a PBS comprising a particles guiding tube (261) for producing a cross sectional V shaped electron beam (266).

FIG. 10 is a schematic side view of pairs of shaped electrodes (287a, 287b) provided for a PBS.

FIG. 11 is a schematic side view of pairs of electrodes (307a to 307n) provided for a PBS producing a rotating electric or magnetic field [e.g. a drive circuit providing deflecting voltages can be coupled with the electrodes and swich respective pairs in a rotative manner in any direction, rotational speed, frequency, etc.]. The electrodes (307a to 307n) can provide deflecting fields not only horizontal or vertical but provided in any desired plane. A multipole element can be created which can e.g. correct an astigmatism. A controllable quadrupole having a pair of facing positive and a substantially orthogonal pair of facing negative electrodes can be also provided, etc. An electric field or a magnetic field can be formed by applying forming voltages and according to the principle of the invention by changing distances between respective (facing, adjacent, etc.) pairs of electrodes (307a to 307n). The cross-sectional shape of the ion (electron) beam can be thus corrected in X and Y directions. The rotating magnetic field can be produced with an alternative current (AC), by combining a low-frequency sine and cosine modulation signal with a higher frequency carrier signal and applying the combined signal to coils such that the magnetic field alternates at a frequency of the carrier signal and rotates at a frequency of a modulation signal, or first, second, third, etc., signals can be applied to respective coils, electrodes, etc., the signals can have each variable frequencies and a constant amplitude, increasing and decreasing frequencies can be combined to produce the rotating field. The electrodes (or coils) can be driven with direct current (DC).

FIG. 12 is a schematic oblique view of a PBS forming an array of guiding tubes (321) [e.g. in a form of a matrix; equal or symmetrical electrostatic converging fields can be provided on either side of the matrix; refraction on the part of apertures in the matrix can be identified as an aperture lens effect].

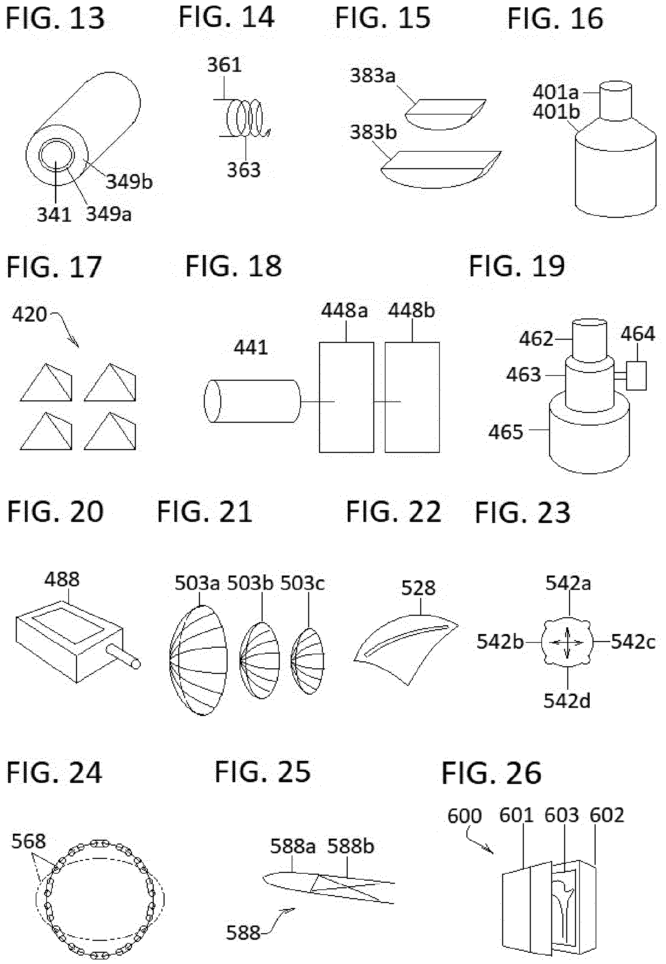

FIG. 13 is a schematic oblique view of a PBS comprising a particles guiding tube (341) which can be provided with a protective film (349a) and insulated with an insulating layer (349b) [e.g. against leakage of an electric field, a magnetic field, etc.].

FIG. 14 is a schematic oblique view of a PBS comprising a particles guiding tube (361) providing a rotating electric and/or mangetic field (363) [e.g. by means of proposed transveresely movable electrodes (not shown); a circular and/or elliptical polarization can be provided, etc.].

FIG. 15 is a schematic oblique view of a PBS providing electrostatic diverging lenses (383a, 383b). [Further excursion of the beam off the tube axis can be limited by the apertures in a matrix (not shown) which can have a high positive potential so that higher beam currents may be employed and can have a given radius.]

FIG. 16 is a schematic oblique view of a PBS providing various diameters guide tubes (401a, 401b). [Various apparatuses can include a narrow neck portion, an enlarged bulb portion, etc.].

FIG. 17 is a schematic oblique view of a PBS providing an electrostatic diverging lenses array (420). The shown embodiment shows the deflection system (420) which can direct an electron beam in a particular direction [e.g. the electron beam can be deflected, bent, turned, converged, diverged towards a predetermined aperture in a matrix which can give a cross-sectional shape to the beam corresponding to a particular matrix aperture. Further (converging) electrostatic lens systems, compenstaing systems, system eleminating incidental diverging forces, etc., can focuse the beam e.g. on a (storage) screen, etc. A maximum off-axis excursion of the beam can be primarily determined by the off-axis disposition of the apertures in the matrix which can be of electrically nonconducting material. By using electrostatic lenses, an increase in the number of beams and high density can be achieved improving thus the throughput of an exposure apparatus and high resolution performance].

FIG. 18 is a schematic oblique view of a PBS comprising a guide tube (441) functionally coupled with beam image controllers (448a, 448b) which can detect primary electrons, secondary electrons, backscattered electrons, etc. [The image controllers (448a, 448b) can be represented by fluorescent sreens, photographic plates, image display portions, etc.].

FIG. 19 is a schematic oblique view of a PBS comprising a source vacuum enclosure (462) [which can include a field emission tip supported by an insulated filament /the field emitter may be of the cold emitter or zirconiated type and an insulation of recrystallized alumina ceramic, etc./, an electrostatic lens /which can be an anode of titanium alloy or molybdenum and which can be composed of three lens elements wherein the first and the second can receive conductive loops and can be mounted in a ring, a spider structure, etc., and controllably defining and sizing the electron beam, a differential pressure aperture; the surface of the first lens element can be of gold, silver or platinum], a system vacuum enclosure (463) [which can include a stop limiting and defining a beam, a condenser lens, a beam cross-over, an objective lens; the vacuum enclosure may include a multi-pin feedtrhough, gold seals, etc.], a vacuum pump (464) [which can pump to suitable levels, e.g. 10⁻⁵ to 10⁻⁶ torr, and which can be an electrical vacuum pump, a passive pump, preferably a getter the non-evaporated porous type, e.g. using zirconium powder sintered with graphite powder, and having toroidal or other forms, the getter may be heated under a vacuum for a predetermined period of time /e.g. under a vacuum of 10⁻³ torr at 900 degrees C for ten minutes] and an enlarged portion (465) [which can include a probe stage and a specimen stage, a specimen holder, a sample chamber enclosing a wafer, an XY /or XYZ for oblique observation/ stage /e.g. sample table with an axis pulse motor/ with a cross roller guide, etc.; measuring devices with various measuring accuracies can be provided for measuring a positional relationship between the probe and the specimen, e.g. in perpendicular directions; the measuring devices can include an optical microscope, a CCD camera, an image forming device, etc.; the enlarged portion (465) can provide a vacuum environment, it can be coupled with a vacuum pump, etc.; the above cited components and non-cited components can be controlled by respective control circuits and computers (microchips) contained by a control device]. Each electrode in the shown example can be provided and constructed according to the principle of the invention and the voltages can be applied to establish appropriate parameters, the currents may be exponential function of the voltage. The voltages can be stepped between the three lens elements up to the final third lens element acting as a final accelerating voltage which aditionally infulences the chromatic aberration and the spherical aberration. [Scan stigmator coil assembly can be further provided to position the beam relative to a differential pressure aparture; valve assembly controlling the flow of gases to and from the source enclosure and making a sealed connection to an associated beam system; the gun may be provided in a suitable gun housing, with a corona shield, etc. Alternatively, the electron gun cathode and the electron gun lens can be enclosed in an electron gun chamber and the electron beam can be converged by an objective lens to irradiate a wafer in the sample chamber, etc., a secondary electron detector can be further provided and placed outside the column or incorporated and placed above or below the objective to improve the detection efficiency for observation at higher resolution. The electron gun lens and the objective lens can be electrostatic field lens constructed according to the invention.]

FIG. 20 is a schematic perspective view of a PBS coupled with a probe sampler (488). [A particles guiding tube with transversely movably arranged electrodes providing a transverse electric field can accelerate and/or focus a particle flow provided in a sampling probe which can filter the sample and provide a faster analyzer respones by reducing the volume of the sample system; the probe (488) can be inserted into a material to be sampled with the sampler; it can collect traced gas from the rest test area of an object; it can be used as a leak-testing probe, etc.].

FIG. 21 is a schematic oblique view of a PBS providing electrostatic flat convex lenses (503a, 503b, 503c) [which can comprise particles guiding tubes and pairs of transversely movably arranged electrodes (only electrode fields connecting curves shown) which can be provided opposite around the circumference of the guiding tubes].

FIG. 22 is a schematic perspective view of a PBS coupled with an image controller (528) [which can include a slit, a ccd camera a display apparatus, etc.].

FIG. 23 is a schematic front view of a PBS comprising a particles guiding tube (not shown) [which can have a case to which an ion pump, a non-evaporable getter pump /e.g. made of a sintered body of Zr, Fe, Cu, etc., absorbing residual gas by physical absorption, or by chemical absorption depending on a kind of gas; the getter pump may be operated at ordinar temperature/, etc., can be mounted, and an electron gun chamber defined by a diaphragm with a sleeve, a movable diaphragm with a defined through hole [or a plurality of holes] and coupled with an aperture drive unit, etc.; an electron gun cathode of the field emission type can be included with an elecron gun lens, an objective lens and a multipole lens with transversely movable electrodes (542a, 542b, 542c, 542d) according to the principle of the invention and providing a controllable transverse electric field to accelerate and/or focus a particle flow. The electrodes can be composed of circular sections providing the transverse electric field and flexible electrical conductors electrically conecting the circular sections. Other technical solutions can be adopted to provide the same effect and enabling a transverse movement of the electrodes (542a, 542b, 542c, 542d). The magnetic field type lens converging an electron beam by the lens effect of a magnetic field produced by an electomagnet which need a magnetic yoke for shaping the magnetic field. In a normal scanning electron microscope the lens construction can include three-stage focusing lenses (a stage of objective lens and two stages of condenser lens). Additional lenses can be prepared for alignment correction, for astigmatism correction. The magnetic lenses can provide excellent aberration property. A short focus and hight excitation lens may be necessary to obtain an excellent aberration property in a low energy region. The electron gun of high brightness (e.g. a field emission type, a cold-cathode electron gun) may be employed to compensate a lower electron energy increasing the influence of aberration of an (objective) lens.

The brightness of a charged particle beam source is related to the number of charged particles emitted per area and the solid angle to which the particles are emitted. A (gallium) liquid metal ion source (LMIS) is very bright but provides a low beam current at high resolution. Plasma ion sources are much less bright but have larger virtual source sizes, therefore, it cannot be focused to as small of a spot as the beam from an LMIS. Inductively coupled plasma (ICP) sources can be used for a focused beam of charged particles [i.e. electrons or ions] in a narrower energy range than a duoplasmatron source which enables a narrower focusing. The ICP sources can have a high voltage bipolar power supply sourcing one or more voltages or currents [e.g. in an ion mode the source can operate in a high positive potential with respect to the ground and the extractor in a high negative voltage with respect to the source.] The present invention providing adjustable electrode spacing can be used in instruments with different operating parameters in various sources and in the optical elements in the focusing columns according to the charged particle beam characteristic and the application.

The electron gun lens, the focusing lens, the objective lens /which can be constructed as einzel lens and composed of three electrodes in a ceramics insulator holder; typically a ground potential can be applied to two electrodes on both upper and lower sides and a negative or positive lens voltage can be applied to an intermediate electrode; by applying the voltage, a focusing lens effect can be generated/, the multipole lens, can be formed as an electrostatic field lens controllable and movable, in that case the transversely movable electrodes (542a, 542b, 542c, 542d) can provide transverse electric fields by the electrodes. A controllable movable multi-pole lens system can thus be created [e.g. for scanning of a beam and for correction of astigmatism]. The electrodes (542a, 542b, 542c, 542d) can be disc, cylinder, etc., shaped. An electron beam emitted from the electron gun cathode point may be converged at an electron gun lens point to form a crossover at a central position of the multi-pole lens, further, the electron beam may be demagnified from the center of the objective lens to form a reduced image on a sample surface. The electrostatic field producing lenses system can be more compact and lighter as compared to one employing the magnetic field type lenses. The acceleration voltage for operation should be low [e.g. about 1 kV] to prevent electron irradiation damage of a semiconductor wafer and to prevent its charge-up. Lower voltages needed to opearte the gun obviate the need for complex designs to avoid voltage discharges which can damage parts or disrupt operation of the apparatus [e.g. a microscope] which results in a lower cost and higher reliability. A bias voltage can be provided which can be opposite in polarity to an accelerating voltage to decelerate the electrons of the beam to stop above a specimen or object surface to provide a non-destructive device [e.g. in a mirror microscopy].

A secondary electron detector increasing secondary electrons /in a scanning type/ with a microchannel plate and an anode plate can be further mounted on a lower surface, etc. A plurality detectors can be used, a detector can comprise an electron sensor for converting an electron beam into an electric signal, a detector comprising an optical sensor for converting an electron beam into light and converting the light into an electric signal. The plurality of detectors can be placed within a vacuum chamber. Electron or light conditions can be adjusted on the basis of conditions detected by a charge coupled device (CCD) based detector comprising a CCD sensor and a camera placed in the atmosphere. Secondary electrons can be amplified by a microchannel plate (MCP), then impinge on a fluorescent plate converting the secondary electrons into an optical signal which can be converted by an optical lens in the atmosphere through a feed through formed in a vacuum chamber and focused on the CCD sensor to form an image in the camera. A time delay integration (TDI) detector can have a TDI sensor placed within a vacuum chamber, a fluorescent plate can be disposed in front thereof through a light transmission means such as a fiber optic plate (FOP) or the like; the secondary electrons enter the fluorescent plate through the MCP, the fluorescent plate converts the secondary electrons into an optical signal transmitted to the TDI sensor, an electric output from the TDI sensor can be transmitted to a camera through a pin provided in a feed through unit. Or, both the CCD inspecting apparatus and the TDI inspecting apparatus can have the MCP and the fluorescent plate placed in a vacuum chamber with a feed through and optical lenses with the CCD sensor or the TDI sensor, respective, and the camera placed in the atmosphere; an optical sensor can be provided in the CCD detector and the TDI detector for detecting light. The defect inspecting aparatus can for example have a primary optical system with an electron gun and guiding the primary electron beam to a sample and a secondary optical system for guiding the secondary electron beam to the detection system; an electron bombarded sensor [e.g. for a higher resolution and a longer image capturing time such as an electron bombarded charge-coupled device (EBCCD) or an electron-bombarded time delay integration (EBTDI)] can adjust the optical axis of an electron beam using the invention proposed system of regulable electrodes, a TDI sensor can capture an image of the sample and a second CCD sensor can evaluate defective site based on the TDI image capture [the detectors can be seleted upon amount of signal, S/N ratio; the S/N ratio can be improved with an increased number of electrons taken for an image or with a longer image capturing duration, because a larger number of electrons per pixel results in a reduction in noise component due to fluctuations in luminance and the like, the modulation transfer function (MTF) can be improved, a smaller pixel size sensors can be provided]. The inspecting apparatus can be irradiated by the electron beam, reflected electrons, back scattered electrons, Auger electrons, optical electrons [e.g. UV light, DUV light, laser light, scattered light], combinations, etc. A quartz or holow fiber can be used in introducing the light to a sample.

FIG. 24 is a schematic front view of a PBS comprising a variable controllable electromagnetic or electrostatic lens which can be coupled with a variable controlable cylindrical actuator (568) [which can be comprised of a chain-like structure, etc.] which can change its chape to define a charged particle beam, to modify the position, cross-sectional shape or other characteristic of the beam, to form a beam focus, eventually to remove cross-sectional asymmetries in the beam or to reduce astigmatism. Deflection coils or electrostatic plates or rods, permanent magnets, etc., can be coupled with the shown actuator (568) as a (coil) mounting structure. Control signals can be static or dynamic to provide static or dynamic beam deflection, positioning and/or quadrupolar stigmatizing. The actuator (568) can be e.g. coupled with a first electrode, a second electrode, a third electrode, or others. Windings can be provided about the actuator creating stigmating fields extending through electrostatic lens to correct cross-sectional assymmetries of the beam, thus the characteristic of a beam passing through an electrostatic lens can be modified by the use of electromagnetic windings. Ceramic insulators can be provided between the electrodes which can receive adjusting potentials. Beam focusing fields can be provided between the first and the second and between the second and the third electrodes. If the electron optical system can be composed of only an electrostatic lens, the entire apparatus can be made very small. If an Einzel lens was used as an electrostatic lens it can be difficult to reduce the size of the apparatus without deteriorating the performance and to obtain high resolution. If the charged particle is a negatively charged particle beam, a positive voltage can be applied to all the lens electrodes others than the final electrode closest to the sample and the contrary for a positively charged particle beam. A convenient potential can be applied between the final acceleration voltage and the first lens electrode immediately above the final electrode. In order to obtain high resolution, it can be useful to bring the sample as close as possible to the final lens.

FIG. 25 is a schematic front view of an actuator (588) [which can comprise a hydraulic part (588a) and a mechanical part (588b), etc.] usable in a PBS comprising a variable controllable electromagnetic or electrostatic lens.

FIG. 26 is a schematic perspective illustration of a PBS provided as an apparatus (600) for digitalization of photographic negatives or X-ray photos. X-ray can be generated by an X-ray tube, a vacuum tube that uses a high voltage to accelerate the electrons by a hot cahode to a high velocity. The high velocity electrons collide with a metal target, the anode, creating X-rays. In medical application, the target can be tungsten or alloy of rhenium and tungsten, molybdenum.

In crystallography, a coper target, cobalt can be used. In medical projectional radiography using X-ray radiation is used that bones contain a high concentration of calcium which efficiently aborsbs X-ray. Fluoroscopy can be used using an X-ray source and a fluorescent screen which can be coupled with an X-ray image intensifier, a CCD video camera. In photography, reflected light rays from the object expose the film to produce an image. In radiography, X-ray that pass through the object expose the film to produce an image. In black-and-white photographic film, there is usually one layer of silver halide crystals. When exposed silver halide grains are developed, the silver halide crystals are converted to metallic silver, which blocks light and appears as the black part of the film negative. Metallic silver is a very good electrical conductor.

The apparatus (600) can include a first portion (601) which can include a source of (negatively or positively) charged particles, one or more particle guiding tubes [preferably an array, or movably arranged particles guiding tube, or group of tubes, etc.] guiding a charged particles flow [e.g. electrones]; the guiding tubes can optionally include at least two transversely movable electrodes providing a transverse electric or magnetic field to extract, accelerate and/or focus the particle flow. The apparatus (600) can include a second portion (602) which can comprise a detector for display in an ancilliary video receiver equipment, a CCD camera, a screen, a scanning device, etc. An X-ray photo, a photographic film negative (603) can be put between the first and the second portion (601 and 602). Metallic silver provided on the negative film or the X-ray photo can influence the particle flow which can be recorded by the camera, displayed on the screen, digitalized by other means including an image processor [e.g. creating a digital negative, etc.].

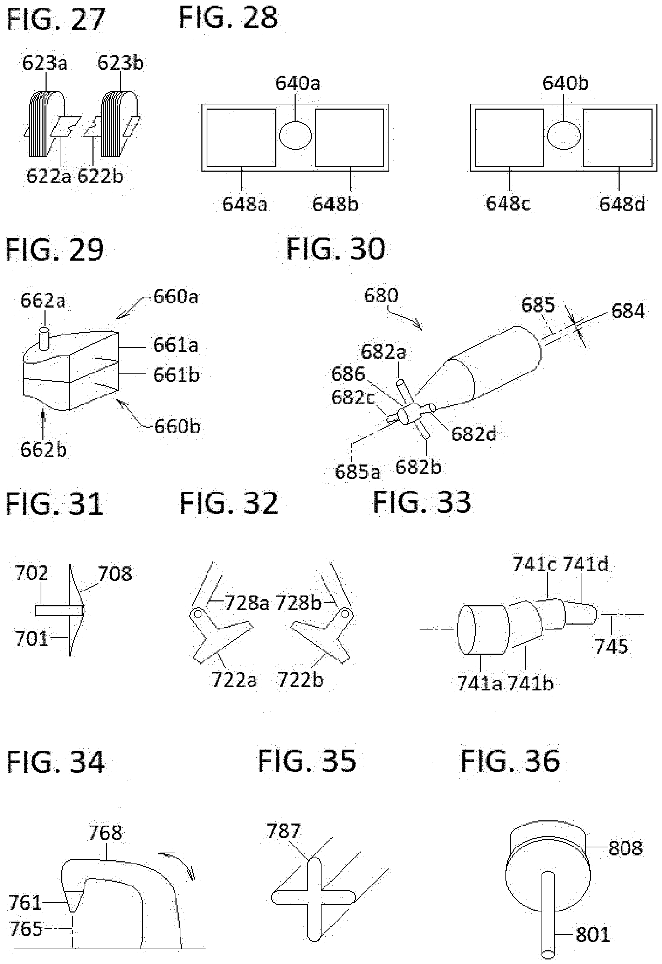

FIG. 27 is a schematic oblique view of pairs of transversely movable electrodes (622a, 622b) to provide a transverse magnetic field, wherein a charged particle flow can be extracted and/or accelerated and/or focused by the electrodes (622a, 622b) which can be provided in two windings (623a, 623b) [which can have any shape; the movement can be provided by various ways: the coils (623a, 623b) can be coupled with moving means /e.g. electromagnetic, mechanical, etc., actuators/, the electrodes (622a, 622b) can be movable inside the windings (623a, 623b) by various means /e.g. actuators/, the electrodes (622a, 622b) can be movable by means of an electromagnetic field provided by the coil /which can be coupled with various types of DC sources, AC sources having various frequencies, etc./; the electrodes (622a, 622b) can be from various types of electrical conductors, magnetic conductors, layered constructions wherein a part provided inside the windings (623a, 623b) can be from soft or hard magnetic material; the electrodes (622a, 622b) can have various shapes and various shapes of adjacent ends /e.g. round, square, oval, parabolic, etc./ which can (partially) overlap and which can form electrostatic or electromagnetic lenses; the electrodes (622a, 622b) can be flat as shown or can have other forms, e.g. bars, tubes, etc.; only a basic mechanism is shown, the windings can be seated in various holders, low-friction high polymer material sliding members, rollers, rails, movement generating units, drive units having a piezo-electric element, DC motors or ultrasonic motors, pulse motors, etc.]. A sealing portion can be provided to seal a high vacuum chamber (enclosure) with penetrating electrodes (622a, 622b) (not shown).

FIG. 28 is a schematic front view of a PBS which can be provided in pairs forming lenses (640a, 640b) configured in a separated eye ray configuration. The shown embodiment can be provided as electro-active accommodating lens [e.g. in a stereo electro optical devices such as a scanning microscope, etc.]. The shown embodiment can provide focusing (accommodating) function. Each optical electrical lens (640a, 640b) can be independently focused based on a convergence angle which can be calculated based upon data from sensors (648a, 648b, 648c, 648d) [shown in lateral positions but any other position is feasable] wherein a relative convergence angle is inversely proportional to the distance between the respective lens (640a, 640b) and an observed spot on a sample surface. Each lens (640a, 640b) [e.g. provided in an array] can be focused using trigonometric principles. Focus sensors (648a, 648b, 648c, 648d) can periodically generate/transmit electromagnetic sensing signals producing one or more (fixed direction or rotating) magnetic fields with different parameters which can be sensed by the focus sensors provided by the other of the lenses (640a, 640b) which each can determine a relative convergence angle between the two lenses based on the detected signals/fields and which can focus the particle beam accordingly. The system can further comprise a particle beam source, a control unit with a processor and a memory and coupled to focuse the lenses (640a, 640b) and the sensors (648a, 648b, 648c, 648d). The sensors can be any type of a sensing device [e.g. nonparallel generating/receiving coils having a suitable frequency and duty cycle /the coils can be driven by AC power supply or a (varied) DC power suppply/, radio frequency sensors /the coils or other types of sensors can be provided in pairs or in a plurality of coils oriented in various directions and providing/measuring a larger number of angles, a fixed direciton or a rotating magnetic field can be provided/, optical /e.g. charge-coupled device (CCD) area sensors, active-pixel sensors (APS), complementary metal-oxide-semiconductor (CMOS) sensors, infrared, laser sensors, etc./, acoustical sensors /inclusive of ultrasonic sensors/, electric field sensors, magnetic field sensors, combined sensors, etc.; electromagnetic sensing signals can have various frequencies /e.g. less than 50 MHz, 13-20 MHz, 13.56 MHZ, resonant frequencies, etc.; a (AM - varied amplitudes or FM - varied frequencies) beam steering method can be provided by the radio frequency sensors]. The sensors provided at each lens (640a, 640b) can directly measure the relative convergence angle and/or each lens (640a, 640b) can sens the sensors of the other lens. The system may be (automatically) calibrated to respond to a viewer's inter-pupilary distance, a gaze angle, etc.

FIG. 29 is a schematic perspective illustration of a PBS provided in pairs forming lenses (660a, 660b) configured in a separated eye ray configuration. Each lens (660a, 660b) can comprise a particles guiding tube (661a, 661b) and transversely movable electrodes (662a, 662b) providing a respective electro- magnetic field to extract and/or accelerate and/or focus a particle flow. [The above described components can be provided in a suitable housing having tubular or other shapes with other necessary components /e.g. a particle beam source, a control unit, external memory devices, external communication interfaces such as displays, acoustic controls, etc., an apparatus body, an apparatus stand, various positioning, sliding, moving mechanisms, etc./].

FIG. 30 is a schematic perspective illustration of a PBS (680) providing transversely movable electrodes (682a, 682b, 682c, 682d) which can be provided in opposite pairs (682a and 682b; 682c and 682d). The electrons or ions in the passed (focused, converged, etc.) beam will emerge from an approximately square portion of the image. [The shown embodiment can be provided in a monoscopic or stereoscopic (medical) electro optical device.]. The electrodes (682a, 682b, 682c, 682d) can be placed in different distances (684) from an optical axis (685), errors such as comatic aberration, diffraction can be reduced by a suitable choice of the opening angle of the beam according to the energy dispertion directions in the beam. A deflection unit (686) can deflect by means of a suitable excitation the beam about the optical axis (685) to center the beam focused on a sample. Several eccentric beams and/or stereo beams can be formed by adding other transvereselly movable electrodes or by time sequencing. A plurality of non-juxtaposed particle emitting surfaces or left eye/right eye particle emitting surfaces can be provided [e.g. in a form of discrete, electron-emitting field emitters each producing its own beam of electrons, each of these beams can have its beam-limiting openings provided by the transveresly movable electrodes [e.g. provided in opposite pairs or different constellations such as stars, diaphragm shutter types, focal plane shutter types, etc.]. Particle-emitting surfaces can emit particles within a limited opening angle, the eccentirc diaphragm opening position can be located so far from the axis (685) that the opening can no longer be illuminated. Assistive lens can be placed in the vicinity of the electron-emitting constituent surface to be located in a focal plane of the lens to provide essentially parallel beam with the optical axis. The particle-emitting constituent surface can have various orientation with respect to the optical axis (685), such that the beam does not demonstrate symmetry about an axis (685a) parallel to the optical axis (685).

FIG. 31 is a schematic partial detailed cross sectional view of a transversely movable electrode (702) provided in a particle guiding tube (701) providing a vacuum; the movable electrode can be provided in the vacuum or can be provided in the atmosphere wherein a suitable sealing means (708) [which can be a membrane, a foil, etc., and which can be provided from exterior or interior] can be provided to keep the vacuum inside the tube (701) [e.g. flexible polymers, metals, metal alloys, etc.].

FIG. 32 is a schematic partial detailed crosss sectional view of transversely movable electrodes (722a, 722b) which can be provided in a particle guiding tube (not shown) and which can have various defined shapes [e.g. a circular section, semicircle, rotational curve, symmetrical, asymmetrical, enlarged, two or three dimensionaly shaped /e.g. can have a straight geometry, i.e. an aperture can have a constant diameter, or a counterbore of a different diameter, a beveled edge, a chamfered edge, tapered edge, spherical shapes, etc., can be added on the downstream or upstream/, combinations, multi aperture systems, etc.] and which can be coupled with various actuators (728a, 728b) [e.g. mechanical, pneumatic, hydraulic, electromagnetic, etc.; various moving mechanisms may be used, etc.].

FIG. 33 is a schematic perspective illustration of an apparatus according to the present invention which can comprise transversely movable electrodes (not shown) which can be provided in a particle guiding tube which can be composed of oriented or movable sections (741a, 741b, 741c, 741d) which can with help of the transversely movable electrodes provided in various types of lenses adjust [e.g. the (multiple charged) particle beam can be deflected (bent, tilted) by deflectors, e.g. by 5 to 30 degrees; an eccentricity can be adjusted; an incident plane, a reflection plane, a workpiece chamber can be adjusted, etc.] the optical axis (745) [various types of 2 or 3-dimensional articulated, slide, rotating, etc. mechanisms and actuators can be provided, e.g. actuators using the piezoelectric element because of a high response performance and an easy miniaturization, servo-control systems, etc.]. A primary charged particle beam can contain a plurality of charged particle pulses which can be detected by the deflector configured to form a plurality of deflected charged particle beams. A detector can detect a plurality of signals generated by a plurality of probe spots [e.g. in one-dimensional, or two-dimensional pattern, a Lissajous pattern, a matrix, an array, etc.] which can be formed by the plurality of deflected particle beams.

A controller can obtain an information on the formation of the deflected charged particle beam of the plurality of the charged particle beams and can obtain an information on the detection of the signal of the plurality of signals, both informations can correlate with the deflected charged particle beam. The controller can control the deflectors, a scanning system, the detector, a driving mechanism, a sample transport system, etc. The controller can contain a memory, a processor to execute preprogrammed instructions.

The device can contain a charged particle source [e.g having a pulsed radio frequency in a range of 100 MHz to 10 GHz], a beam forming cavity, an accelerating cavity and a focusing cavity [or a beam concentrator can be provided as a combination of the aforementioned cavities with a plurality of regulable deflectors /e.g. radio frequency cavities or MEMS deflectors coordinated by the controller/]. The deflector may include a plurality of deflectors each forming the plurality of deflected charged particle beams based on an operating frequency which can be synchronised with a source frequency by a determined positive value.

An electron optical system [with a single or multiple lens system] to focus the plurality of deflected charged particle beams on a sample and a charged particle beam scanning system to scan the plurality of the beams on the sample may be further included. Other imaging system can be functionally coupled such as optical imaging systems, light detection, x-ray detection, etc.

Various sensors /e.g. position sensitive detectors, photo-interrupter type sensors, etc., wherein position sensor circuits can convert a signal from position sensors to a voltage value for (pitch, yaw, etc.) (piezoelectric, electromagnetic, etc.) actuators to move into a predetermined position/, shake sensors /e.g. shake sensing gyroscopes, angular-velocity sensors, etc.; correction optical systems can be then driven in order to prevent (compensate) an image shake, to counteract apparatus shakes of a given or typical or measured or presumed frequency and in given direction of pitch, yaw, etc.; a filter circuit (a low pass filter and a high pass filter) can be further functionally coupled for cutting noise nad drift of the signal form the gyroscopes, etc.; and an integration circuit can be provided for changing a signal of the angular velocity into a signal of an angle, etc./, movement sensors, deviation detectors, temperature sensors, etc., can provide a feedback information to the controller /e.g. a microcomputer, etc./ digitally processing signals from sensing circuits to output a compensation sequence. A temperature sensor can be used to compensate a change in performance by temperature, in order to optimalize a compensation under an operating temperature condition. The drive voltage of the actuators and other parameters can be rectified. User guiding interfaces can be further provided. The deflection of the optical axis can be adjusted according to desired paramaters and/or a specific application [e.g. a position adjuster, a moving unit, a driving mechanism, etc., can be provided for each bending member of the movable sections (741a, 741b, 741c, 741d) which can be provided from an exterior, an interior, detachably attached, coupled, etc.]. The system can be provided for a stereovision as well.

The system can be used in multiple-beam scanning electron microscopes (SEMs) [e.g. using continuous electron beams or pulsed electron (clustered) beams generated by a pulsed charged particle source] which can use transversely movable electrodes to a dynamic adjustemnt of magnification and resolution [e.g. different resolutions can be used for different tasks]. The adjustments can be manual or automated. The system can be used in micromechanical systems (MEMs) with aperture array forming multile beamlets wherein the aperture electrodes can be transversely movably provided in according to the present invention.

In a multi-beam devices the Coulomb effect can occur betgween beamlets which can cause degradation. The Coulomb effect can occur in the longitudinal and the transverse directions. Cluster generation can solve the problem. Multiple cluster generators can be used for clustering multiple beams. Filtering cavities configured downstream the cluster generators may be used and provided with a dynamic electromagnetic field [which can be one or more dynamic electric fields provided in cycles accelerating and decelerating charged particles and with a direction changing perpendicular to the direction of moving clusters between movable electrodes and controlled by the controller] to deflect stray charged particles with regulable deflectors and a regulable aperture plate. Variable (multiple) deflectors according to the present invention can deflect the clusters to become more concentrated for high and scallable brightness and uniform current. Multiple deflectors can create scalable pathways to mitigate Coulomb effects. The multiple deflectors can in a further effort cluster the beams and release the beams to pass throught a crossover region sequentially. An interaction volume of the beamlets can be larger than the spot size of the beamlets and may overlap. Secondary electrons generated by each beamlet can be detected by the detector [e.g. a solid state detector, Everhart-Thornley detector including scintillators, etc.]. Overlapping may cause crosstalk problems. Deflecting and detecting in different times may solve the problem.

The inspection device can be coupled with the sample [e.g. wafer] transport systems [e.g. robots, robotic arms, drones, etc., and other components [e.g. electron source, a gun apeture plate which can be provided regulable according to the present invention similarly as a condenser lens which can both vary the currents of the primary beamlets, a beam splitter /which can include (regulable) aperture plates or electrostatic deflectors/, a deflection scanning unit; primary and secondary systems with primary and secondary optical axes can be provided].

The electron source can include a cathode and an anode or extractor configurable according to the present invention with transversely movable electrodes. The primary electron source may include a superconducting radio frequency (SCRF) photo-injector, a normal conduction radion frequency (NCRF) photo-injector, a high voltage direct current (DC) photo-emission gun, radio frequency accelerator light injector, combinations, etc. High quantum efficiency photocathodes may be used. An RF chopper system may be included.

Other regulable elements can be included in a source conversion units [e.g. image forming elements /which may include a plurality of (regulable) microdeflectors or (regulable) microlenses/, an array of aberration components /which may include a field curvature compensator array with a plurality of regulable microlenses, a (MEMS) aperture array, an astigmatic compensator array with a plurality of regulable micro-astigmatism correctors or of beam-limiting (regulable) apertures /which can be disposed in various (linear, helical, rectangular, circular, etc.) patterns, can form a matrix, an array, etc./, and an array of pre-curved microdeflectors, etc.]. The apertures can be fabricated using photolithography, embossing, ultra-precision laser machining, injection molding, mechanical drilling, etc. The apertures can represent a particle guiding tube and can be provided with movable parts which can provide controllability according to the principle of the invention. The movable parts can narrow the aperture size from zero to the full size of the aperture. Similarly other regulable parts such as lenses, deflectors can provide zero to a predetermined size regulability. They can vary particle optical properties, can balance misalignment, manufacturing tolerances, can correct the spherical and chromatic aberration. The system of the invention can be used for multipole lenses such as dipoles, quadrupoles, etc. The system's regulability can be combined with a time-varying electric or electromagnetic, or magnetic field.

An objective [e.g. with an electromagnetic compound lens, or magnetic or electrostatic lens regulable according to the invention] can focus the beamlets onto a sample. Electrostatic wetting and magnetic wetting can reduce the aberattion of the objective lens. The objective can have a virtual front focus.

A deflection cavity (with regulable deflectors) can receive a beam of electrons pulses from a beamforming cavity. Regulable MEMS deflectors can be used. Any number of deflected electrons can be provided and a plurality of deflection cavities (with regulable deflectors differently oriented providing two-dimensional pattern of probe spots on a sample). Defocusing cavities with regulable electrodes can be further included. The ejected electrons may include emitted electrons, secondary electrons, backscattered electrons, transmitted electrons, Ogier electrons, etc.

Beam raster systems or beam grating systems can be further included. Various types of processing unit can be provided as a controller [e.g. Programmable Logic Array (PLA), Field Programmable Gate Arrays (FPGA), System-on-Chip (SoC), a network processor, and so on] and various memory types can be included, operating systems, applications, image processing systems, communication interfaces, communication networks, measurement circuitries [e.g. to detect the secondary electrons], motorized stages, etc. The controller can communicate with the components of the system [e.g. the acceleration cavity, the beamforming cavity, the deflection cavity, the detector, etc.]. Digital and analog circuits can be included or coupled. Image manipulation software can be used.

Various scan patterns [e.g. one-dimensional, two-dimensional, etc.] can be used for observing samples using the multi-beam device with the controllable components. The frequency scanning can be adjusted by adjusting the source frequency, operating frequency of the deflection cavity, etc. The electronic pulse frequency can be for example in the range of 100 MHz to 10 GHz.

FIG. 34 is a schematic side view of another apparatus which can comprise a guiding tube (761) coupled with an apparatus body (768) [which can be pivotably coupled wherein an optical axis (765) can change its orientation]. The embodiment of the invention can be provided in other joined systems [e.g. including an inspecting apparatus, a power supply rack, a control rack, an image processing rack, a deposition apparatus, an etching apparatus, roughing vacuum pumps, etc.; the inspecting apparatus can comprise an electron beam vacuum chamber, a vacuum transfer system, a main housing with a stage, a vibration isolator, a turbo molecular pump, etc.; the electron beam vacuum chamber may be composed of an electro-optical system, a detection system, an optical microscope, etc.; the electro-optical system can be composed of an electron gun, lenses, which can be provided according to the present invention, etc.; the transfer system can be composed of a vacuum transfer robot, an atmosphere transfer robot, a cassette loader, a variety of position sensors, etc.; other apparatuses such as a chemical mechanical polishing apparatus (CMP), a washing apparatus, a chemical vacuum deposition (CVD) apparatus, a plating apparatus, a lithography apparatus, etc.

FIG. 35 is a schematic oblique view of a shaped charged particle beam (787) shaped by transversely movable electrodes (not shown) which can be provided in a particle guiding tube (not shown) and which can have various defined shapes to shape the beam (787). [A shaped beam can be used in various applications such as a sander, a grinder, a drilling machine; for example in an electron microscope with a bent optical axis of deflected charged particles that is supported by a holding device to a tool spindle of a coordinate drilling machine, wherein a spindle axis passing through a targeted point can partly coincide with the optical axis, etc.].

FIG. 36 is a schematic oblique view of an apparatus according to the present invention which can comprise transversely movable electrodes (not shown) which can be provided in a gas cluster ion beam (GCIB) (801) system which can strike a workpiece in an insulated holder (808). An ion beam source (not shown) can be provided which can include a reduced pressure chamber for forming a gas cluster ion beam, transversely movable electrodes for accelerating the gas cluster ions to form an accelerated gas cluster ion beam along a beam path within the reduced pressure chamber; at least a portion of the accelerated gas cluster ions can be further fragmented and/or dissociated along the beam path /an acceleration voltage can be raised, the range of velocities of ion can be increased, pressure along the beam path may be increased by introducing a gaseous element, an adjustable skimmer aperture provided according to the present invention may be increased or decreased, the accelerated gas cluser ion beam may be irradiated with radiant energy/; charged particles can be removed from the beam path by other transveresly movable electrodes to form an accelerated neutral beam; a workpiece can be put into the reduced pressure chamber to be irradiated. Or the gas cluster ion beam may be generated in a vacuum enclosure, the gas cluster ion beam may be accelerated; a fragmentation or at least partial disociation of gas clusters ma be promoted /a background gas for colliding with the gas cluster ion beam may be provided, the acceleratd gas cluster ion beam may be heated, irradiated, crossed with a gas jet, excited with electrons/, accelerated neutral gas clusters and/or gas monomers may be produced, charged particles may be removed /e.g. by means of an electric field or a magnetic field transversely movable electrodes/ from the beam path to form an acclerated neutral beam comprising acclerated neutral gas clusters and/or acclerated neutral gas monomers; the generating chamber may ionize gas cluster by electron bombardment, the ionization can be controlled to provide intense ionization conditions forming a high proportion of multiply ionized gas clusters in the beam. The neutral beam may consist essentially of gas from the gas cluster beam, of neutral gas monomers. A thermal energy sensor with a thermal sensor controller may be provided in the system to characterize the accelerated neutral beam and to control the irradiated dose. Neutral beam dosimetry may be provided comprising thermal measurement measuring beam induced heating. Electrical current may be measured in a sample of the charged particles removed from the beam. The accelerated neutral beam can clean, smooth, sterilize, abrade, etch, implant, dope, modify, make more or less wettable, more or less biologically active or compatible by the irradiation an article [e.g. a medical instrument, a semiconductor material, a biological material, an optical element, etc.]. A farraday cup, a mechanical scanner, a vacuum pump, an ionizer (operating at a ground potential or at a negative potential), etc., can be further provided as other components in the system.

The present invention can provide a well-focused, accelerated, intense neutral monomer beam usable in many applications. The transversely movable electrodes may be acceleration electrodes [which can be coupled with a permanent magnet array providing magnetic suppression of secondary electrons], suppressor electrodes, grounded electrodes, beam gates [e.g. managing the GCIB dose received by the workpiece and controlled by a beam gate controller opening the beam gate and/or moving the movable electrodes for a predetermined interval which can be calibrated by a dose processor, etc.], a scanned beam-defining aperture, electrostatic deflectors separating the charged and uncharged portions of the GCIB [movable electrostatic deflectors /including an electron suppressor grid electrode/ can be controlled by a dosimetry controller and provided in a plurality of succesive stages each separating a portion of charged portions and each independently controllable, provided in a circuit of a deflector power supply which can be adjusted from zero to a voltage sufficient to completely deflect the ionized portion(s) with a current sensor, etc., undeflected GCIB can travel to the workpiece and the workpiece holder (808) where a GCIB beam current can be collected and flow to a current sensor and an electrical ground], electrostatic mirror reflecting electrodes, electrical grid electrodes, retarding electrodes [e.g. ensuring deceleration of the ionized portion of the GCIB], etc. A magnetic analyzer providing a magnetic field can be used instead of the electrostatic field to separate the charged beam componets from the neutral beam components.

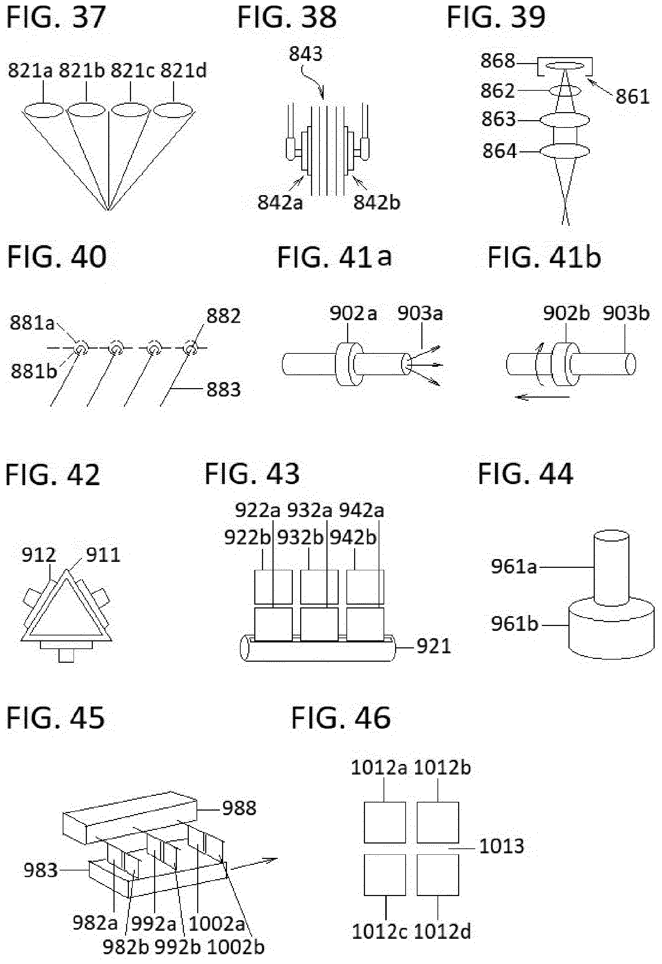

FIG. 37 is a schematic side view of a multi-beam apparatus according to the present invention which can comprise transversely movable electrodes forming electrostatic or electromagnetic lenses (821a, 821b, 821c, 821d) [which can be formed with transversely movable electrodes (not shown) in various layers, forms and groups, and which can be formed as an aperture-deflector assembly, respective a blanker-aperture-deflector assemly, respective a focus electrodes-focus shield electrodes-spray aperture-deflector-object aperture-blanking electrodes-rotator-accelerating column plates-shield electrode-mainfield deflectors-subfield deflectors-lens plates (or blanking apertures)-blanking apertures-immersion lens with movable parts according to the present invention; other optical column compositions are possible for the present system which can include components such as controllers and drivers, a multi-electrode cathode /e.g. a single crystal silicon field emitter microcathode, etc./, a microfabricated ion source /e.g. integrated in the aperture-deflector to block out all spherically aberrated beams/, a single crystal tungsten field emitter, a field emitting tip, a pumping aperture, a gate electrode /e.g. before the focus lens electrode/, BSE detectors, focusing optics, aligment deflector optics /e.g. a quadrupole, an octupole, a non-equisector dodecapole deflectors steering the electron beam into the blanking aperture at the bottom of the electron optical column; the voltage required to blank an off-axis beam can be the same at that for the on-axis beam offering a high blankwidth, conjugate blanking can be provided not to blurr the wafer during the blanking process which can be performed in a a gated manner/, shielding electrodes, etc.; a pattern can be written out into the blanking electrodes; the immersion lens and BSE detectors can provide the primary focusing for beamlets onto a wafer and can detect backscattered electrons; a writing strategy can incorporate stage motion which can be scanned in Y-direction and beams in an X-direction; an electron gun /one for each column and having an electron source an (adjacent) aperture-deflector assembly /e.g. having a spray aperture, an alignment deflector, an object aperture plate and blanking electrodes; each assembly being capable of individually deflecting an electron beam providng an individual current sense for source current regulation; individual blaning can be provided by the blanking electrodes/ and creating a linear array of individual, parallel electron beams independently focusable for example to the blanking aperture/ can be positioned at the top of the column and the wafer at the bottom]. A multi-beam source (not shown) can be coupled with the system which can be used in a high throughtput, multi-column, multi-beam electron beam lithography system. The charged particle beams can be individually focused. The system can be used in various lihography types [e.g. next generation lithography (NGL) and using masks for standard IC chips or maskless systems, e.g. electron beam direct-write (EBDW) systems, both at the ITRS nodes]. The multi-beam can easily overcome (or at least reduce) space-charge effects [within a single column or within a multiple column]. Electron optic imaging systems can have a large demagnification factor which can result in a writing field of view on a waver being much smaller than a lens diameter. A multiple lens system individually focusing multiple beams within a single column design which can provide a solution for an acceptable lens diameter, lying out traces, making contacts, etching silicon substrate, flip chip bonding, etc., can be provided in known ways.

FIG. 38 is a schematic side view of an apparatus according to the present invention which can comprise transversely movable electrodes (842a, 842b) [which can be electrostatic or electromagnetic electrodes of a plurality functional types /e.g. deflectors, focusing electrodes, etc./] which can be provided in a charged particle cluster beam (843). Energetic ionized clusters formed by a beam of uncharged particles can be further disintegrated to produce a beam of energetic atoms. Particles can be ionized, accelerated, unionized particles can be separated. Beam of ionized cluster can impact against a cluster scattering plate to break into unclustered atoms and ions which can be further removed. The atoms' energies can range between 1 to 10 electron volts per atom. The system can be used for deposition of thin films upon substrates. The atoms particles can be produced and accelerated, e.g. by a hot mass of the material to be vaporized; the beam then can escape from the source through an aperture; energies of the atoms can be about 1/10 electron volt per atom; or an expanding plasma can be ignited to expand and impart its kinetic energy to atoms; or beams of solid or gaseous materials can be produced by above mentioned technique using an apparatus according to the present invention with the transversely movable electrodes (842a, 842b) which may control any part of the process inclusive of the final atom beam. Cluster beam can be formed by known techniques from volatile (gaseous) and non-volatile (solid or liquid) materials. The cluster can be ionized by a cathode/anode ionizer and accelerated by [e.g. first and second] apertured electrodes [e.g. with different voltages applied with a difference typically about 2000 to 20,000 volts] which can be regulable accordingly to the present invention. Mass separator techniques can be further used using at least two electrodes [e.g. an entrance and a retarding field electrode which can have a fishnet or a window constructions with eyes provided by movable bands configured to be able to change the apertures' sizes, etc.] constructed accordingly to the present invention. Unionized particles can be separated by deflector electrodes constructed accordingly to the present invention [e.g. typically including two plates wherein at least one can be transversely movable]. After disintegrating the ionized cluster beam by directing the cluster beam against an obstacle [e.g. an oriented cluster scattering plate made of silicon which may be optionally removed so that the apparatus can produce energetic ionized clusters instead of energetic atoms; in the scattering function a perpendicular component of energy can be converted to heat that can cause the atoms of the cluster to leave the cluster, thus the angle of orientation can be varied in according to desired intensity of the forwardly scattered beam]. The ion can be removed by an electrostatic deflection plate which can be also constructed accordingly to the present invention. A forward-scattered beam of atoms can be thus produced. When a target is not a good conductor a deflector can be used to remove ions from the beam [the deflector can include two plates wherein at least one can be transversely movable]. The fnal atom beam with a distribution of energies can be free of clusters and ions. In some applications energetic beams of atoms can be preferred to an energetic beam of clusters [e.g. argon clusters can be used].

FIG. 39 is a schematic side view of an apparatus [which can be an ion projection lithography (IPL) apparatus] according to the present invention which can comprise transversely movable electrodes (861) [which can be a regulable aperture which can form a (multi-beamlet) ion beam; the aperture can be circular or can have another shape which can produce a dot, a circle, a cross, a line or another shape inside a defined pattern], an extraction electrode (862) [which can be used instead of a much thicker mask; which can be composed of a base layer made of silicon or other conductor, a second layer made of an insulator, a third layer made of silicon or other conductor; a controllable pattern generator can be used switching beamlets on or off thus generating various patterns; the pattern generator can be a two electrode blanking system, the two electrodes can be transverselly movable; the pattern generator can electrostatically produce and manipulate a plurality of mico-ion beamlets coupled to a beam reduction and acceleration column; the pattern generator can be formed by a pair of mutually insulated electrodes], an accelerating electrode (863), a focusing (reduction) electrode (864) [which can be both electrostatic lens systems which can be made of a plurality of electrodes; which can be made up of an Einzel lens system including a pair of split electrodes to steer the beamlets by applying suitable voltages. Other setting of transversely movable or fixed electrodes can be provided and other components can be provided such as a charged particle source (868) [e.g. a plasma-formed ion source or an ion source with a low energy spread /preferable to reduce chromatic aberration/ or a multicusp ion source with magnetic filters, or another source; plasma can be generated by an RF antenna [e.g. a quartz antenna], a dc filament, a photo-cathode [e.g. working with a light from an excimer laser (λ=243 nm) and emitting electrons due to a photon energy higer then the surface work function; the photo-cathode can be biased negatively (e.g. 100V) with respect to an anode photoemission electrons can be accelerated towards the anode and can ionize background gas neutrals, thus generating a plasma; the laser can be located at ground potentical and at any distance from a source chamber; the source plasma can be operated in continuous wave or pulsed mode], or otherwise, a linear magnetic filter or a coaxial magnetic filter can be optionally used to decrease energy spread of the ions which can be optionally hydrogen or helium ions, optionally stencil masks, deflectors, field lenses, a sample holder, a wafer with exposed resist layer /wherein voltage breakdown limit for applying a dc voltage between two electrodes can be calculatedy by a Kilpatrick formula *d*=0.01414 V^{3/2} , where d is the distance between the two electrodes in mm and V is the applied voltage expressed in kV. If the voltage between the pattern generator and substrate is 5 kV, then according to the Eq., the minimum distance between them is ^{~}160 µm. Thus the pattern generator and substrate system can be operated without voltage breakdown with an applied voltage of 5 kV and at a separation of >160 µm./, a mechanical stage, a support, an x-y stage, voltage sources, connections of electrodes to the voltage sources, etc.] The system can be designed with or without a beam crossover for various voltages and spacings. A conventional IPL system needs a divergent beam from an ion source with very low energy spread. After exiting form the stencil mask, the beam is further accelerated and then demagnified to form a parallel beam again. The maskless system can eliminate the stencil mask which can be replaced by the patternable multi-beamlet system or the the universal pattern generator. Both systems can include an accelerator to focus the ion beam and to reduce the feature size of the beamlet pattern. Projection or proximity print type lithography systems can be provided. The accelerator or reduction columns can be eliminated in maskless nano beam lithography systems capable of reduction factors of at least 10 to 30 or more and producing sub-50nm feature size with final beam spot size <0.1 µm. By applying a high voltage to the pattern generator or exit electrode and the substrate extracted beamlets can be focused providing the demagnification without the reduction column. The demagnification can be obtained by a self-focusing effect provided by the pattern generator/beam extractor. A maskless nano-beam lithograpy system processing 60 (300mm) wafers per hour and having 30 sec for exposure can have the speed for exposure about 20 cm2/sec. If the resist sensitivity is 20 µC/cm², the total charge required is 20 µC/sec or a current of 20 µA. For 25 nm lithography with 250 nm apertures holes on the pattern generator with 16 gray scales, 12 mA/cm² current density on the resist or 0.12 mA/cm² on the aperture holes can be used. These current density values can be achieved having the multicusp source for either H⁺ or H⁻ ions. [The system can be used in patterning of magnetic media.]

FIG. 40 is a schematic oblique view of a multi-beamlet apparatus according to the present invention which can comprise a beam defining aperture (882) [it can be a plasma or beam forming electrode having a plurality of (typically circular) apertures or channels; it can be connected to a voltage source or to a separate source] and another electrode with transversely movable electrodes [which can comprise two or more transversely movable segments (881a, 881b) and which can be placed in a defined distance; it can be an extraction or beamlet switching electrode formed of an insulator having a plurality of apertures or channels each containing a conductor electircally connected with a programmable voltage source]; the electrodes (882 and 881a, 881b) can be separated by an insulation and can be positively or negatively biased in various applications; a multi-beamlet (883) passing through can be regulated by provided voltages and by position of the segments (881a, 881b); each beamlet can be individually controlled]. A multicusp ion source can provide the ion multi-beamlet [e.g. with low energy spread].

FIGs. 41a and 41b are schematic oblique views of an apparatus according to the present invention which can comprise transversely movable electrodes (902a) [which can be electrostatic or electromagnetic electrodes of a plurality functional types] which can be provided in a circularly non-polarized beam (903a) and transversely movable electrodes (902b) [which can be electrostatic or electromagnetic electrodes of a plurality functional types] which can be provided in a circularly polarized beam (903b). [A relative translationally rotational movement can occur between the one or more transversely movable electrodes (902b) and the circularly polarized beam (903b) which can have different properties and utilization than a circularly non-polarized beam (903a).]

FIG. 42 is a schematic cross sectional view of an apparatus according to the present invention which can comprise transversely movable electrodes (912) [which can be electrostatic or electromagnetic electrodes of a plurality functional types] which can be provided in a non-circular beam guiding tube (911) [e.g. a triangular beam can be provided].

FIG. 43 is a schematic side view of an apparatus according to the present invention which can comprise pairs of transversely movable electrodes (922a, 922b, 932a, 932b, 942a, 942b) [which can be electrostatic or electromagnetic electrodes of a plurality functional types; alternatively different numbers of movable electrodes can be provided in stages] which can be provided in a beam guiding tube (921). The system can be coupled with a particle source, a vacuum pump, etc. Each electrode (pair) can be individually controllable, movable, etc.].

FIG. 44 is a schematic oblique view of an apparatus according to the present invention which can comprise transversely movable electrodes (not shown) which can be provided in a beam guiding tube which can be composed of portions (961a, 961b) with different diameters [e.g. each portion (961a, 961b) can provide different functions].

FIG. 45 is a schematic perspective illustration of an apparatus according to the present invention which can comprise pairs of transversely movable electrodes (982a, 982b, 992a, 992b, 1002a, 1002b) [which can be electrostatic or electromagnetic electrodes] which can be provided along a beam guiding tube wherein a particle flow (983) can be influenced by the transversely movable electrodes (982a, 982b, 992a, 992b, 1002a, 1002b). The system can be coupled with a controller (988). Each electrode (982a, 982b, 992a, 992b, 1002a, 1002b) can be individually controllable, movable, etc.

FIG. 46 is a schematic cross sectional view of an apparatus according to the present invention which can comprise transversely movable electrodes (1012a, 1012b, 1012c, 1012d) [which can be electrostatic or electromagnetic electrodes of a plurality functional types and which can be movable diagonally or in other directions] which can be provided in a non-circular beam guiding tube (not shown) and which can provide a cross-shaped particle flow (1013).

Common features of FIGs. 1 to 46.

The components as shown in the drawings can have different layouts, proportions, orientations, materials, etc. Features shown and described in the drawings and the description can be combined, interchanged, multiplied, etc. Some features can be omitted to maintain functionality of the proposed embodiments.

The principle of this invention may be employed with a variety of positively or negatively charged particle beam systems. The invention can utilize a DC power supply, an AC voltage or a pulsating DC voltage applied between components of the system. DC magnetic field can be applied via permanent magnets, DC power supply, battery power sources, etc. AC voltages can be supplied via AC power supplies having various frequencies [e.g. inclusive of radio frequency, mid-frequency, 0-100 MHz frequency, etc.].

Cathodes and anodes provided in the system and other components such es electrodes can have various shapes [e.g. U shapes, plates, rings, etc.].

The particles guiding tube with transveresely movably arranged electrodes providing a transverse electric and/or magnetic field can be used as an electromagnetic condenser lens, an electromagnetic objective lens, an electromagnetic projector lens, an image shake preventing lens, tilting lens, various types of apertures [e.g. inclusive of apertures of various particle sources such as plasma sources, wherein the apertures regulables according to the present invention can be further coupled with nozzles, discharge cavities, etc.].

Other components such as permanent magnets, magnet holding members, sample chambers, prober exchange chambers, moving mechanisms, driving means, stages, display apparatuses, CCD cameras, CMOS cameras, probers comprising a workstation (WS) for computer aided design (CAD), etc., can be coupled with the proposed system.

No limitations are intended others than as described in the claims. The present invention is not limited to the described exemplary embodiments. It should be noted that various modifications of the proposed system can be made without departing from the scope of the invention as defined by the claims.

Elements, integers or components having known equivalents thereof are herein incorporated as if individually set forth.

The elements, integers, components, materials, techniques, etc., described in this specification reflect the state of knowledge at the time of the filling of this application and may be developed in the future.

### Industrial Applicability

The present invention can be useful for medical applications, e.g. thermionic or cold cathode ray tubes, exposure apparatuses, ionizers for purification of air, water or sewage, plasma accelerators, plasma etching, plasma treatment [e.g. surface modification, cleaning, etc.], plasma enhanced chemical vapor deposition (PECVD) [e.g. Silicon Oxide coating], atomic motors, electron optical systems, electron beam memory systems, electron lithographic devices, sample image display devices, detectors for detecting secondary particles from a sample, probers, electron beam testers, evacuation systems, electron microscopes, mirror projection systems, scanning electron microscopes (SEM), non-scanning electron microscopes, transmission electron microscopes (TEM), gate valvesoptical microscopes, focused ion beam (FIB) systems, FIB patterning or films, scanning FIB systems, charged particle beam systems, charged particle beam direct-write lithography, focused ion beam maskless direct write lithography, electron projection lithography, maskless ion beam projection lithography, a plasma formed ion-beam projection lithography (IPL) systems, electron beam lithography systems, X-ray lithography, nanolithography, extreme ultraviolet lithography (EUVL), projection lithography (IPL), atomic-force-microscope (AFM) lithography, stencil mask systems, patternable multibeamlet systems, maskless micro-ion-beam reduction lithography (MMRL), maskless nano-beam lithography (MNBL), direct print systems, proximity print systems, projection print systems, prober systems, micro-sampling systems, systems including ion pumps, getter ion pumps, etc., in flying-spot tubes, charactrons, numeroscopes, mass spectroscopy, energy dispersive spectroscopy (EDS) utilizing x-ray spectrum, ion implantation, micromachining, apparatus deriving an accelerated neutral monomer and/or neutral gas cluster ion beam (GCIB) [e.g. to smooth, reactively or physically etch, clean, form deposits on, grow films on, or modify surfaces of for example metals, semiconductors, dielectric materials; using Argon as a source gas for processing the surfaces of implantable medical devices], nozzle jets, magnetic or electrostatic size separators, monomer filters, low-mass filters, cluster ion size selectors, devices processing semiconductor surfaces, electrical circuits, electrical devices, optical elements, micro-electrical mechanical systems (MEMS) devices, devices producing insulating drug coating, dielectric films, electrically insulating films, processing electrically conductive or slightly conductive or semiconductive materials (coatings, layers), neutral monomer beam processing, vidicons or solar cells production, improving optical properties of lenses by deposing a thin film onto their surfaces, thin film depositon techniques, electron beam evaporation techniques, integrated circuits (ICs), manufacturing inspection, etc.

A device equipped with the proposed adjustable electrodes charged particles guiding system can be used in stereoscopy, with interchangeable charged particles sources, in a modular system providing scalability and interchageability, wherein the modules may be catalogued.

The system proposes cost savings by the proposed modularity.

The proposed system can offer a flexible charged particle beam systems used to image, analyze, and modify samples on a microscopic or nanoscopic scale.

The system proposes variability and interchangeability in an electrical optical apparatus.

## Claims

1. A particle beam system, comprising: a particle guiding tube, the system **characterised in that** it comprises: one or more transversely movable electrodes to provide a transverse electric and/or magnetic field, wherein a particle flow can be influenced by said one or more transversely movable electrodes.

2. The particle beam system according to claim 1, wherein at least one component is provided at least partially with a protective film.

3. The particle beam system according to claim 1, wherein said particle guiding tube is insulated with an insulation layer, wherein at least one said insulation layer is selected from the group consisting of electrical insulations, optical insulations, thermical insulations, electromagnetical insulations, mechanical insulations, or combinations thereof.

4. The particle beam system according to claim 1, forming a mono and/or stereo particle path.

5. The particle beam system according to claim 1, producing a cross-sectionally shaped beam.

6. The particle beam system according to claim 5, wherein at least one said cross-sectionally shaped beam is selected from the group consisting of V shaped beams, round shaped beams, square shaped beams, cross-shaped beams, character shaped beams, free shaped beams, geometrically shaped beams, electron beams, ion beams, neutral particle beams, cluster beams, or combinations thereof.

7. The particle beam system according to claim 1, providing an adjustable optical axis.

8. The particle beam system according to claim 1, producing a rotating electric and/or magnetic field.

9. The particle beam system according to claim 1, providing a circularly polarized particle beam.

10. The particle beam system according to claim 1, wherein at least one said transversely movable electrode is selected from the group consisting of gate electrodes, biasing electrodes, source biasing electrodes, blanking electrodes, beam acceptance apertures, beam defining apertures, plasma electrodes, exit electrodes, beam forming electrodes, extraction electrodes, acceleration electrodes, accelerating columns, deceleration electrodes, decelerating columns, split electrodes, suppresor electrodes, grounded electrodes, shield electrodes, focus shield electrodes, multiaperture electrodes, beam gates, beam defining appertures, column plates, accelerating column plates, scanned beam defining apertures, focusing electrodes, electrical grid electrodes, entrance electrodes, reflecting electrodes, retarding electrodes, lenses, einzel lenses, condenser lenses, objectiv lenses, electrostatic lenses, magnetic lenses, immersion lenses, deflectors, rotators, extractor electrodes, focusing columns, or combinations thereof.

11. The particle beam system according to claim 1, coupled with an electrocomponent, wherein at least one said electrocomponent is selected from the group consisting of apparatus bodies, deposition apparatuses, cathodes, photocathodes, anodes, electrodes, gate electrodes, biasing electrodes, source biasing electrodes, blanking electrodes, beam acceptance apertures, beam defining apertures, plasma electrodes, exit electrodes, beam forming electrodes, extraction electrodes, acceleration electrodes, accelerating columns, deceleration electrodes, decelerating columns, split electrodes, suppresor electrodes, grounded electrodes, shield electrodes, focus shield electrodes, multiaperture electrodes, beam gates, beam defining appertures, column plates, accelerating column plates, scanned beam defining apertures, focusing electrodes, electrical grid electrodes, entrance electrodes, reflecting electrodes, retarding electrodes, lenses, einzel lenses, condenser lenses, objectiv lenses, electrostatic lenses, magnetic lenses, immersion lenses, deflectors, rotators, extractor electrodes, focusing columns, ionizers, resists, stencil masks, masks, magnetic analyzers, insulators, pins, controls, displays, discharge shields, split Faraday shields, sublimation coils, metal oxide semiconductor devices, writing heads, verification heads, reading heads, head drives, lasers, viewing screens, storage screens, storage targets, electron beam sources, electron guns, ion beam sources, multicusp ion sources, gas cluster ion beam sources, neutral beam sources, forward-scattered beam sources, plasma beam sources, inductively coupled plasma sources, plasma sources, x-ray sources, clustered charged particle beam sources, multi-beam sources, light sources, power sources, voltage sources, current sources, drive circuits, beam image controllers, scanning deflectors, deflectors, stereo deflectors, shake sensors, shake sensing gyroscopes, probe samplers, cameras, processors, memories, x-ray detectors, scintillators, spectrometers, spectrum analyzing systems, antennas, sensors, emitted field sensors, image sensors, active-pixel devices, charge coupled devices, time delay integrations, electronic amplifiers, microchannel plates, fluorescent plates, magnetrons, shunts, robotic arms, robots, drones, photo injectors, light injectors, photo emission guns, or combinations thereof.

12. The particle beam system according to claim 1, coupled with a mechanocomponent, wherein at least one said mechanocomponent is selected from the group consisting of actuators, drive means, housings, optical systems, vacuum chambers, low pressure chambers, reduced pressure chambers, vacuum pumps, vacuum manifolds, conduits, plasma chambers, sample chambers, process chambers, probe chambers, probe moving mechanisms, sample moving mechanisms, said electrodes moving mechanisms, mechanical moving systems, pneumatic moving systems, hydraulic moving systems, insulators, insulator sheets, envelopes, flanges, rings, mandrils, aperture size controllers, sealing means, lenses, lens systems, fiber optic plates, gas feed systems, gas evacuating systems, permanent magnets, permanent magnet arrays, nozzles, discharge cavities, turbines, wheels, propellers, pumps, regulators, injectors, cooling systems, or combinations thereof.

13. The particle beam system according to claim 1, forming lenses configured in a separate eye ray configuration.

14. A method for providing a particle beam, the method **characterised in that** it comprises the steps of:
- providing a particle beam system comprising a particle guiding tube, one or more transversely movably arranged electrodes to provide a transverse electric and/or magnetic field;
- transveresly relatively moving said one or more electrodes to desired distances and/or shapes;
- influencing a particle flow.

15. A digitizer of photographic or X-ray images, **characterised in that** it comprises: a first portion including a source of charged particles, a particle guiding tube, a particle lens system having transversely movable electrodes and a second portion including a scanning screen coupled with an image processor.
